(19)

**Europäisches Patentamt**
**European Patent Office**
**Office européen des brevets**

(11) **EP 2 406 825 B1**

(12) **EUROPÄISCHE PATENTSCHRIFT**

(45) Veröffentlichungstag und Bekanntmachung des Hinweises auf die Patenterteilung:
**18.10.2017 Patentblatt 2017/42**

(51) Int Cl.:
***H01L 27/146*** (2006.01)   ***H01L 31/0232*** (2014.01)

(21) Anmeldenummer: **10711177.5**

(22) Anmeldetag: **08.03.2010**

(86) Internationale Anmeldenummer:
**PCT/EP2010/052923**

(87) Internationale Veröffentlichungsnummer:
**WO 2010/102985 (16.09.2010 Gazette 2010/37)**

(54) **VERFAHREN ZUR HERSTELLUNG EINER VIELZAHL VON MIKROOPTOELEKTRONISCHEN BAUELEMENTEN UND MIKROOPTOELEKTRONISCHES BAUELEMENT**

METHOD FOR PRODUCING A MULTIPLICITY OF MICRO-OPTOELECTRONIC COMPONENTS AND MICRO-OPTOELECTRONIC COMPONENT

PROCÉDÉ DE FABRICATION D'UNE PLURALITÉ DE COMPOSANTS MICRO-OPTOÉLECTRONIQUES ET COMPOSANT MICRO-OPTOÉLECTRONIQUE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **13.03.2009 DE 102009013112**

(43) Veröffentlichungstag der Anmeldung:
**18.01.2012 Patentblatt 2012/03**

(73) Patentinhaber: **Fraunhofer-Gesellschaft zur Förderung der angewandten Forschung e.V.**
**80686 München (DE)**

(72) Erfinder: **MARENCO, Norman**
**25596 Bokelrehm (DE)**

(74) Vertreter: **Zimmermann, Tankred Klaus et al Schoppe, Zimmermann, Stöckeler Zinkler, Schenk & Partner mbB Patentanwälte Radlkoferstrasse 2 81373 München (DE)**

(56) Entgegenhaltungen:
WO-A2-2008/006504   JP-A- 7 202 149
JP-A- 2007 004 471   US-A- 5 227 313
US-A1- 2006 043 262   US-A1- 2007 052 050
US-A1- 2007 259 463   US-A1- 2008 122 055
US-A1- 2008 290 435

• **REN NG ET AL: "Light Field Photography with a Hand-held Plenoptic Camera", STANDFORD TECH REPORT CTSR,, 1 February 2005 (2005-02-01), pages 1-11, XP008138449,**

**Beschreibung**

Die Erfindung bezieht sich auf die Integration von mikrooptischen Elementen und mikroelektronischen Bildsensoren.

Ein genereller Trend ist die Miniaturisierung der Optik und Elektronik bildaufnehmender Vorrichtungen in Bezug auf ihre Fläche bzw. flächenmäßige Ausdehnung und in Bezug auf ihre Dicke bzw. ihrer Gesamthöhe, die sich aus der Dicke der optischen Elemente und der Dicke der Sensorelemente sowie dem Abstand zwischen dem optischen Element und dem jeweiligen Bildsensor ergibt. Mit der zunehmenden Miniaturisierung ergeben sich erhöhte Anforderungen an die Justierung der optischen Elemente gegenüber den entsprechenden Sensorelementen in Bezug auf ihren Abstand zueinander sowie einer Rotation zueinander.

Gleichzeitig ist es wünschenswert, auch in derart miniaturisierten optoelektronischen Systemen optische Elemente mit unterschiedlichsten optischen Eigenschaften einsetzen zu können, um neben der klassischen Fotografie beispielsweise auch eine Lichtfeld-Fotografie oder eine Spektralzerlegung des Lichts realisieren zu können.

Bisherige Aufbautechniken, insbesondere für die Lichtfeld-Fotografie, basieren auf diskreten Bauteilen, bei denen jeder Bildsensor mit dem für ihn bestimmten optischen Element einzeln bestückt wird. Die Justage erfolgt über feinmechanische Justiervorrichtungen, mit denen eine Höhenverstellung (z-Richtung) und die laterale Position (x-y-Richtung) permanent oder reversibel eingestellt werden kann. Die Genauigkeit der Justierung ist hier jedoch limitiert, z. B. in einem Bereich von über 20 $\mu$m.

Ein anderer Ansatz zur Justage und Fixierung besteht darin, das Schrumpfen eines UV-härtenden (UV-Ultraviolett) Klebstoffes zur hochgenauen Positionsverschiebung einzusetzen. Dieser wird beispielsweise für die Justage von Glasfasern vor Laserdioden eingesetzt. Dabei wird die Justage dadurch erreicht, dass die UV-Bestrahlung so angepasst wird, dass die Glasfaser in einer möglichst optimalen Position gegenüber der Laserdiode fixiert wird.

Eine andere Möglichkeit besteht darin, Mikroaktuatoren als dynamische Positioniervorrichtung einzusetzen, um das optische Element gegenüber dem Sensorelement optimal zu positionieren.

Die US 2008/0122055 A1 beschreibt ein Verfahren zur Herstellung von Halbleiterkomponenten mit Linsenstrukturen und Linsenhalterungsstrukturen, wobei die vereinzelten Stücke jeweils lediglich eine Linse umfassen. Die 2008/0290435 A1 beschreibt ebenfalls Bauelemente mit jeweils einem Mikrooptik-Element.Die US 2006/0043262 A1 beschäftigt sich ebenfalls mit dem Aufbau von mikroelektronischen Bildgebern, die ein optisches Element pro Bauelement aufweisen. Gleiches gilt für die US 2007/0259463 A1 und die US 2007/0052050 A1. Die US 5,227,313 behandelt ein Konzept zur Herstellung von rückseitenbelichteten Bildsensoren, bei dem die Diffusion von Ionen aus einem Borosilikatwafer zur Dotierung der Sensorelemente genutzt wird. Die JP 7-202149 beschreibt eine Anordnung mit einer in den Substratwafer der Bildsensoranordnung eingebrachten Optik, die aufgrund der Transmissionseigenschaften von Silizium nur im Infrarot-Bereich nutzbar ist. Die WO 2008/006504 beschreibt Halbleiterdetektorsubstrate mit einer Linse auf der Rückseite, die dort gebildet wird, um zu ermöglichen, dass eine Detektionsschicht auf der gegenüberliegenden Vorderseite des Substrates selektiv aufgewachsen werden kann. Das Dokument schlägt also vor, das die auf der Rückseite befindlichen Linsen zur Pixelstrukturierung auf der Vorderseite zu verwenden. Die EP 1215729 widmet sich eigentlich dem Problem unterschiedlicher Verdrahtungsdichten auf Bildsensoren, was im Polierprozess (CMP) zu einem verschieden starken Abtrag führt. Zur Überwindung dieses Problems schlägt das Dokument vor, die Verdrahtungsdichte durch die Anordnung der Schaltkreise um die Bildsensorebene herum zu homogenisieren. Dazu wird das Sensorfeld in vier Quadranten unterteilt, die separat als Schieberegister ausgelesen werden. Die EP 0840502 zeigt einen modularen Aufbau eines Mehrkanalsystems ohne Waferbondtechnik.

Aus den Druckschriften JP2007/004471-A und "Light Field Photography with a Hand-held Plenoptic Camera" (Ren Ng et Al. Stanford Tech Report, CTSR 2005-02, Seiten 1-11) sind die Bildsensoren für die Lichtfeld-Fotografie bekannt.

Ein Ausführungsbeispiel der vorliegenden Erfindung schafft Verfahren zur Herstellung einer Vielzahl von mikrooptoelektronischen Bauelementen, wobei das Verfahren mit den Merkmalen des Anspruchs 1 versehen ist. Einzelne Ausgestaltungen der Erfindung sind Gegenstand der Unteransprüche. Zudem schaffen Ausführungsbeispiele ein Mikrooptoelektronisches Bauelement, wobei die Anordnung mit den Merkmalen des Anspruchs 6 vorgesehen ist. Ausführungsbeispiele schaffen somit integrierte Systeme, die auch als mikrooptoelektronische Systeme (MOES) bezeichnet werden können.

Ausführungsbeispiele der Erfindung ermöglichen eine kostengünstige Massenproduktion mikrooptoelektronischer Bauelemente, die Möglichkeit, mikrooptische Elemente mit nahezu beliebigen optischen Eigenschaften zu integrieren und mikrooptische Elemente gegenüber den ihnen zugeordneten Sensoranordnungen und Sensorelementen präzise lateral und vertikal in Bereichen von weniger als 1 - 2 $\mu$m und mit sehr geringen Rotationsfehlern von weniger als 0,5° zu positionieren. Dabei werden in einem Justierschritt viele Bauteile hergestellt.

Derartige Ausführungsbeispiele ermöglichen eine kostengünstige Herstellung von mikrooptoelektronischen Bauelementen für die Lichtfeld-Fotografie, bei der Lichtanteile abhängig von ihren Einfallswinkeln auf unterschiedliche Lichtsensorelemente der darunter angeordneten Lichtsensoranordnung gelenkt werden.

Bei derartigen Verfahren können die Lichtsensoranordnungen in dem ersten Wafer für eine Vorderseitenbeleuchtung oder Rückseitenbeleuchtung angeordnet sein.

Bei Ausführungsbeispielen, bei denen das erste Waferteilstück für eine Rückseitenbeleuchtung ausgebildet ist, ist das zweite Waferteilstück auf einer Rückseite des ersten Waferteilstücks angeordnet. Solche Ausführungsbeispiele ermöglichen zusätzlich zu geringeren Bauteilhöhen einen verbesserten Füllfaktor und damit eine weitere laterale Miniaturisierung und/oder Verbesserung der Lichterfassung bzw. Bilderfassung bei gleicher Fläche bzw. lateraler Ausdehnung.

Anwendungen der Ausführungsbeispiele ergeben sich in jedem Einsatzbereich von beispielsweise Fotografie oder von Bild- oder Zeilenscannern, sowohl im großvolumigen Consumermarkt als auch in speziellen Nischenprodukten. Ausführungsbeispiele der vorliegenden Erfindung können beispielsweise im Bereich der Lichtfeld-Aufnahme als integrierte Mikrooptik-Sensorelemente mit einem breiten Anwendungsspektrum eingesetzt werden, z. B. zum Scannen von Oberflächenprofilen als Dokumentationshilfe in der Qualitätsanalyse oder Archäologie. Biologie und Life-Science können mit speziell ausgerüsteten Mikroskopen ihre Objekte dreidimensional aufzeichnen und nachträglich in verschiedenen Tiefen analysieren. Damit wird eine vollständige Analyse selbst von schnellen Zellvorgängen möglich. Im Consumerbereich und im Profibereich können Kameras angeboten werden, mit denen bei der Aufnahme keine Fokussierung nötig ist, und die damit nicht nur bei schlechten Lichtverhältnissen im Vorteil sind, sondern auch an Regentagen oder bei der Unterwasserfotografie, denn störende kleine Tropfen oder Partikel direkt vor der Optik können herausgefiltert werden. Weitere Anwendungsfälle für Ausführungsbeispiele der vorliegenden Erfindung sind die Aufnahme und Analyse von Bildern außerhalb des sichtbaren Spektrums, oder durch Echtfarb-Aufnahmen. Umwelttechnik, Medizin und Wissenschaft können hiermit neue und/oder billigere Werkzeuge an die Hand bekommen. Auch die maschinelle Bildverarbeitung kann durch quasi dreidimensionale Bildinformationen neue Algorithmen entwickeln und gegebenenfalls durch Verzicht auf mehrere Kameras kostengünstiger realisiert werden.

In diesen Anwendungsbereichen ermöglichen Ausführungsbeispiele eine extrem präzise Positionierung der Elemente zueinander im Bereich unterhalb von 1-5 $\mu$m lateral und 1-10 $\mu$m vertikal, sodass die Abbildung der Mikrooptik auf dem Bildsensor an einer stets genau definierten Position erfolgt. Dies ist erforderlich, um mikrooptische Systeme mit angeschlossener elektronischer Bildverarbeitung als kostengünstiges Massenprodukt anbieten zu können, ohne eine mechanische oder elektronische Kalibrierung der Abbildungsposition vornehmen zu müssen. Die Kenntnis der präzisen Abbildungsposition ist vor allem erforderlich, wenn Elemente des Bildsensors miteinander, mit der realen Welt oder mit einem dreidimensionalen Modell einer Abbildung in Korrelation gebracht werden sollen. Auch bei der Abbildung eines Lichtspektrums auf eine Reihe von Sensorelementen ist die Genauigkeit des Abbildungsortes eines der wichtigsten möglichen Kriterien für die Zuordnung der Abbildung zu den einzelnen Wellenlängenbereichen des einfallenden Lichtes.

<u>Kurzbeschreibung der Figuren</u>

Ausführungsbeispiele der vorliegenden Erfindung werden nachfolgend unter Bezugnahme auf die beiliegenden Zeichnungen näher erläutert.

Fig. 1A      zeigt einen Querschnitt eines Vergleichsbeispiels eines Waferstapelteilstücks bzw. mikrooptischen Bauelements für eine Rückseitenbeleuchtung aus einem ersten Waferteilstück und einem darüber angeordneten zweiten Waferteilstück.

Fig. 1B      zeigt eine Aufsicht eines Waferteilstücks oder auch Waferstapelteilstücks mit sphärischen mikrooptischen Elementen.

Fig. 1C      zeigt eine Aufsicht eines Waferteilstücks oder auch Waferstapelteilstücks mit zylindrischen mikrooptischen Elementen.

Fig. 1D      zeigt ein Verfahren zur Herstellung eines Waferstapels mit einer Vielzahl von mikrooptischen Bauelementen gemäß Fig. 1A.

Fig. 1E      zeigt eine schematische Darstellung der Lichtfeld-Fotografie.

Fig. 2A      zeigt ein Vergleichsbeispiel eines Waferstapelteilstücks bzw. mikrooptischen Bauelements aus einem ersten Waferteilstück und einem darüber angeordneten Waferteilstück, wobei die Lichtsensoranordnung und die Lichtsensorelemente in dem ersten Waferteilstück für eine Vorderseitenbeleuchtung ausgebildet sind.

Fig. 3A      zeigt einen Querschnitt eines Vergleichsbeispiels eines Waferstapelteilstücks bzw. mikrooptischen Bauelements aus einem ersten Waferteilstück, einem darüber angeordneten zweiten Waferteilstück und einem zwischen diesen angeordneten weiteren Waferteilstück, das Kavitäten aufweist.

Fig. 3B      zeigt ein Verfahren zum Herstellen eines Waferstapels gemäß Fig. 3A.

Fig. 4A      zeigt einen Querschnitt eines Vergleichsbeispiels eines Waferstapelteilstücks bzw. mikrooptischen Bauelements aus einem ersten Waferteilstück und einem darüber angeordneten zweiten Waferteilstück, wobei das erste Waferteilstück Kavitäten über den Lichtsensoranordnungen aufweist.

Fig. 4B      zeigt ein Flussdiagramm eines Vergleichsbeispiels eines Verfahrens zur Herstellung eines Waferstapelteilstücks gemäß Fig. 4A.

Fig. 5A      zeigt einen Querschnitt eines Vergleichsbeispiels eines Waferteilstücks bzw. mikrooptischen Bauelements, wobei die Lichtsensoranordnungen für eine Rückseitenbeleuchtung auf einer ersten Seite angeordnet sind, und der Wafer auf der gegenüberliegenden Seite optisch strukturiert ist.

Fig. 5B      zeigt ein Flussdiagramm eines Vergleichsbeispiels zur Herstellung eines Waferteilstücks gemäß Fig. 5A.

Fig. 6A      zeigt einen Querschnitt eines Vergleichsbeispiels eines Waferteilstücks bzw. mikrooptischen Bauelements mit Lichtsensoranordnungen, die für eine Rückseitenbeleuchtung auf der Vorderseite angeordnet sind, und auf der gegenüberliegenden Seite additiv mikrooptische Elemente aufgebracht sind.

Fig. 6B      zeigt ein Flussdiagramm eines Vergleichsbeispiels eines Verfahrens zum Herstellen eines Waferteilstücks gemäß Fig. 6A.

Fig. 7A      zeigt eine Abwandlung der Fig. 1A als Ausführungsbeispiel mit einem lichtdurchlässigen Fenster in dem ersten Waferteilstück.

Fig. 8A      zeigt ein Vergleichsbeispiel einer Lichtsensoranordnung mit einer darüber angeordneten mikrooptischen Linse gemäß Fig. 1A zur Erläuterung der Dimensionierungen.

Fig. 8B-8D      zeigen verschiedene Dimensionierungsbeispiele gemäß Fig. 1A.

Dabei werden in der vorliegenden Anmeldung für Objekte und Funktionseinheiten, die gleiche oder ähnliche funktionelle Eigenschaften aufweisen, gleiche Bezugszeichen verwendet.

Detaillierte Beschreibung der Erfindung

Lichtsensoranordnungen weisen eine Vielzahl von beispielsweise in lateraler Richtung (x- und/oder y-Richtung) benachbarten Lichtsensorelementen auf. Als Lichtsensoren bzw. kurz "Sensoren" werden je nach Kontext bzw. wie aus dem jeweiligen Kontext ersichtlich, einzelne Lichtsensoranordnungen als Lichtsensoren bzw. eine Vielzahl von beispielsweise in lateraler Richtung benachbarten Lichtsensoranordnungen bezeichnet.

Beispiele für Lichtsensorelemente sind sogenannte Pixel. Ein "Pixel" bezeichnet einen Abbildungspunkt eines im Allgemeinen zweidimensionalen Bildes oder Bildsensors bzw. Bildsensorelements. Der Begriff "Pixel" ist abgeleitet aus dem englischen Begriff "picture element".

Als "Füllfaktor" eines Pixels auf einem Bildsensor wird die effektiv dem Lichteinfall ausgesetzte Sensorfläche pro Pixel bezeichnet. Dabei geht das daneben einfallende Licht für die Bildaufnahme verloren.

Ausführungsbeispiele der vorliegenden Erfindung können verschiedenste Arten von Bildsensoren bzw. Lichtsensorelementen aufweisen, z. B. in CCD-Technologie (CCD - Charge Coupled Devices") oder in CMOS-Technologie (CMOS - Complementary Metal Oxide Semiconductor"). Die CCD-Lichtsensoren können einen höheren Füllfaktor erreichen, da die pro Belichtung aufgenommenen Ladungen als Sequenz zur Ausleseeinheit verschoben werden und so nur wenig Platz für andere Schaltungselemente außer den Sensoren benötigt wird. Sie haben jedoch typischerweise schlechtere Bildeigenschaften als CMOS-Lichtsensoren, da beispielsweise ein Übersprechen zwischen den Punkten einer Reihe stattfinden kann.

CMOS-Sensoren benötigen für jedes einzelne Pixel mehrere Transistoren, die die aufgenommenen Ladungen verstärken, speichern und Restladungen im Sensor löschen können. Manche Schaltungskonzepte sehen bis zu sechs Transistoren vor, um eine optimale Aufnahmequalität bezüglich Bildrauschen und Dynamikumfang zu erreichen.

Der lichtempfindliche Teil eines Lichtsensorelements kann beispielsweise als Photodiode oder Phototransistor ausgebildet sein, bei denen ein auf sie einfallendes Licht, im sichtbaren und/oder unsichtbaren Wellenlängenbereich, an einem p-n-Übergang in einen elektrischen Strom umgewandelt wird, wobei der elektrische Strom abhängig von der Lichtintensität ist. Als Halbleitermaterial können beispielsweise Silizium oder Germanium verwendet werden, aber auch andere Halbleitermaterialien, unter anderem auch organische Halbleitermaterialien, kommen in Betracht.

Der lichtempfindliche Teil einer Pixelzelle oder eines Lichtsensorelements ist im Halbleiterkristall, z.B. Siliziumkristall, angeordnet, darüber werden beispielsweise in mehreren Prozessschritten strukturierte Schichten aus Metall und Glas abgeschieden. Bei dem Entwurf und der Herstellung der Sensoren wird darauf geachtet, dass der Lichteinfall auf die lichtempfindliche Zone in dem Siliziumkristall ermöglicht bleibt, indem die Verdrahtungen entsprechend so gestaltet werden, dass sie neben den lichtempfindlichen Bereichen bzw. Sensorflächen verlaufen.

Eine Möglichkeit, eine weitere Miniaturisierung von beispielsweise siliziumbasierten Bildsensoren zu erzielen, besteht darin, die Siliziumwafer so weit auszudünnen, dass die Belichtung oder Beleuchtung von der Rückseite des Siliziumwafers erfolgen kann. Dabei wird die Seite des Wafers, auf der die Lichtsensorelemente angeordnet bzw. gebildet werden, als "Vorderseite" bezeichnet und die dieser Vorderseite gegenüberliegende Seite als "Rückseite" des Wafers bezeichnet. Die Eindringtiefe des Lichtes hängt von der Wellenlänge ab, sie ist hoch für Rotlicht und sehr niedrig für blaues Licht. Für Infrarotstrahlung ist Silizium transparent. Daraus ergibt sich, dass ein Wafer auf etwa 20 $\mu$m oder weniger gedünnt werden muss, um effektiv genug Licht auf den Sensorzellen detektieren zu können.

Die Transparenz bzw. Lichtdurchlässigkeit einer Materials hängt von der Wellenlänge des Lichts, dem Material bzw. Eigenschaften des Materials sowie der Dicke des Materials ab. Dabei beschreibt der Transmissionsgrad den Anteil des einfallenden Lichts oder Lichtstroms, der das Material, hier beispielsweise das Wafermaterial, komplett durchdringt bzw. in dem Fall eines in dem Halbleitermaterial angeordneten lichtempfindlichen Teils eines Lichtsensorelements bis zu dem lichtempfindlichen Teil komplett durchdringt. Dabei wird ein Material, beispielsweise ein Substratmaterial oder Wafermaterial, als transparent bezeichnet, wenn der Transmissionsgrad größer als 50 %, vorzugsweise größer als 70 % und besonders vorzugsweise größer als 90 % ist.

Durch die Rückseitenbelichtung ergeben sich neue Freiheitsgrade in der Verdrahtung der Sensorelemente, so können beispielsweise mehr Transistoren integriert oder bessere Füllfaktoren erreicht werden. Ausführungsbeispiele der vorliegenden Erfindung können Pixelgrößen unterhalb von 1 $\mu$m aufweisen. Durch derartige Sub-Mikrometer-Pixel kann eine höhere Auflösung bei gleicher Größe des Bildsensors erreicht werden bzw. kleinere Sensorchips mit gleicher oder besserer Leistung erzielt werden.

Ausführungsbeispiele der erfindungsgemäßen Verfahren ermöglichen eine kostengünstige Herstellung von Systemen mit derartigen mikrooptoelektronischen Bauelementen auf Waferebene, wobei die optische Strukturierung der Wafer und/oder die Erzeugung der Lichtsensorelemente in den Wafern auf Waferebene erfolgen kann. Beispielsweise ist die Integration der Bauelemente kostengünstiger, da die aufwändige Justage und/oder Nachjustierung, wie sie in herkömmlichen Systemen notwendig ist, entfällt. Weitere Ausführungsbeispiele ermöglichen hochgenaue und irreversible Fügungen von Wafern und den entsprechenden Waferteilen, wobei in dem Justierschritt, bei dem beispielsweise der erste und der zweite Wafer zueinander justiert werden, viele mikrooptoelektronische Bauteile in einem Justierschritt und einem Fügeschritt hergestellt werden können. Die Verbindung von Wafern aus verschiedenen Fertigungstechnologien miteinander, hier beispielsweise einem optisch strukturierten Glaswafer und einem mit Lichtsensorelementen versehenen Siliziumwafer, kann auch als "hybride Integration" bezeichnet werden.

Im Folgenden werden Ausführungsbeispiele der Herstellung von mikrooptoelektronischen Bauelementen und Ausführungsbeispiele von mikrooptoelektronischen Bauelementen beschrieben, bei denen der erste Wafer oder das erste Waferteilstück auch allgemein als Bildsensor-Wafer bezeichnet wird und der zweite Wafer bzw. das zweite Waferteilstück als Glaswafer ausgebildet ist und entsprechend bezeichnet wird.

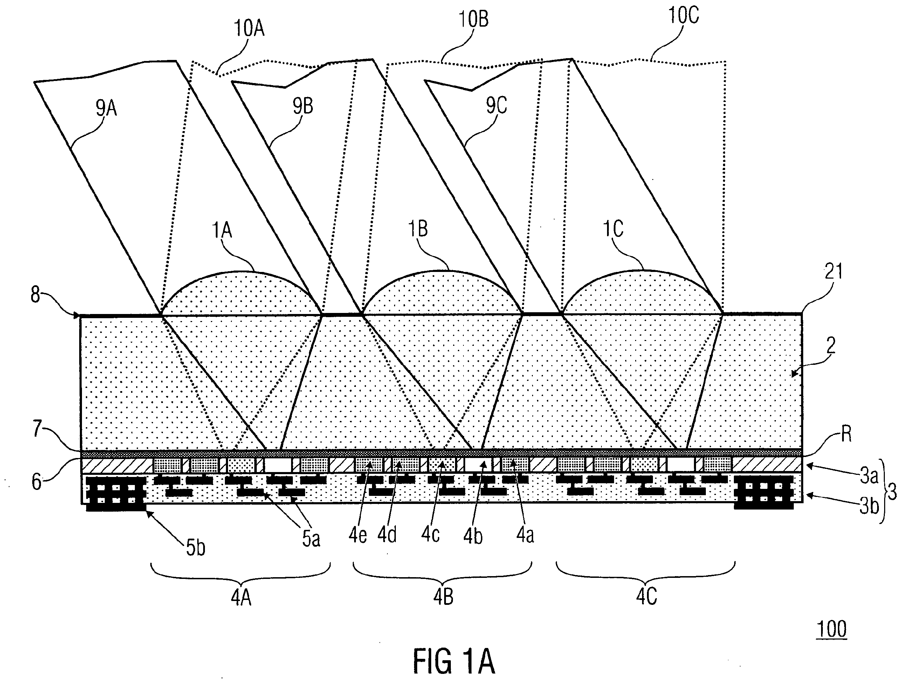

Fig. 1A zeigt einen Querschnitt eines Vergleichsbeispiels eines mikrooptoelektronischen Bauelements 100, das einen Stapel aus einem ersten Waferteilstück 3 und einem darüber angeordneten zweiten Waferteilstück 2 aufweist, wobei das erste Waferteilstück 3 und das zweite Waferteilstück 2 durch ein Waferbondingverfahren miteinander verbunden wurden. Das erste Waferteilstück 3 weist eine erste Schicht oder allgemein einen ersten Teil 3a aus Halbleitermaterial mit darin dotierten Zonen, beispielsweise den zuvor erläuterten lichtempfindlichen Zonen, aber auch den beispielsweise für die CMOS-Sensoren notwendigen weiteren Transistoren auf, sowie eine zweite Schicht 3b bzw. allgemein einen zweiten Teil 3b mit den Verdrahtungsebenen, beispielsweise aus Polysilizium, Metallen, Oxiden oder Nitriden. Die Verdrahtungsebenen bzw. Verdrahtungsstrukturen 5a, 5b des Bildsensor-Wafers 3 sind in Fig. 1A symbolisch angedeutet. Dabei kann weiter zwischen in dem zweiten Teil 3b des Bildsensor-Wafers verborgenen Verbindungsebenen 5a unterschieden werden und den mit 5b bezeichneten außen liegenden Kontaktflächen als elektrische Verbindung zu anderen Bauteilen. Die Verdrahtungsstrukturen 5a und 5b sind beispielsweise aus Polysilizium oder Metallen gebildet, die wiederum durch Oxide oder Nitride lateral und vertikal, wie in Fig. 1A symbolisch dargestellt, voneinander elektrisch isoliert sind.

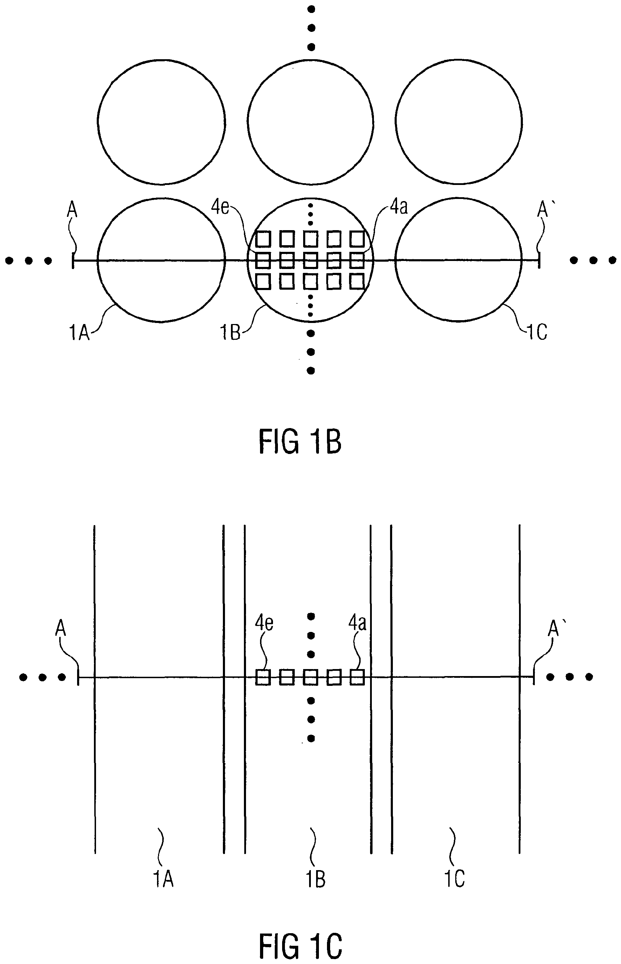

In dem ersten Teil 3a des Bildsensor-Wafers 3 sind drei Lichtsensoranordnungen 4A - 4C angeordnet, die wiederum jede fünf Lichtsensorelemente 4a, 4b, 4c, 4d, 4e aufweisen wobei lediglich für die mittlere Lichtsensoranordnung die Bezugszeichen eingezeichnet sind. Die Lichtsensorelemente 4a - 4e können auch als Pixelelemente bezeichnet

werden. Bezugzeichen 6 bezeichnet eine schützende Schicht als Diffusionsbarriere auf der Oberfläche des Sensorwafers 3, die in Fig. 1A jedoch nicht sichtbar ist. Bezugzeichen 7 bezeichnet eine optionale Adhäsionsschicht bzw. Klebeschicht zur Verbindung des Glaswafers 2 mit dem Sensorwafer 3, wie sie beispielsweise bei Vergleichsbeispielen mit adhäsivem Bonding vorliegt. Bei anderen Waferbondingverfahren, z. B. dem anodischen Bonding, weist der Stapel keine solche Adhäsionsschicht 7 auf. Die Adhäsionsschicht 7 kann optisch transparent sein, zumindest teilweise optisch transparent sein, phosphoreszierend sein oder ähnliches sein. Das Glaswaferteilstück 2 ist derart strukturiert, dass darin drei mikrooptische Elemente 1A bis 1C gebildet sind. Die mikrooptischen Elemente 1 können beispielsweise radiale Linsen, elliptische Linsen, sphärische Linsen oder zylindrische Linsen sein, wie später anhand der Fig. 1B und 1C noch näher erläutert wird, oder andere mikrooptische Elemente mit beispielsweise refraktiven oder diffraktiven Eigenschaften sein. Vergleichsbeispiele können zusätzlich eine strukturierte, lichtundurchlässige Schicht 8 zur Vermeidung von Streulicht aufweisen, die beispielsweise auf der Oberfläche des Glaswafers 2 zwischen den mikrooptischen Elementen 1 angeordnet ist.

Fig. 1A zeigt ferner drei symbolische Lichtbündel 9A, 9B und 9C, die für eine beliebige Anzahl von unterschiedlichen Lichtbündeln stehen, die jeweils auf verschiedene mikrooptische Elemente 1A, 1B und 1C fallen, wobei die mikrooptischen Elemente 1A, 1B und 1C jeweils derart optisch strukturiert sind, dass die Lichtstrahlen 9A, 9B und 9C auf dasselbe Lichtsensorelement 4b der jeweils unter den mikrooptischen Elementen 1A, 1B und 1C angeordneten Lichtsensoranordnungen 4A, 4B und 4C gelenkt werden. Entsprechendes gilt für die ebenfalls annähernd aus einer gleichen Richtung einfallenden Lichtbündel 10A, 10B und 10C, die jedoch gegenüber den Lichtbündeln 9A - 9C aus einer anderen bzw. unterschiedlichen Richtung auf die mikrooptischen Elemente 1A - 1C fallen, und alle auf dasselbe Lichtsensorelement, nämlich 4c, der jeweiligen Lichtsensoranordnung 4A - 4C gelenkt werden. In anderen Worten, jeder Lichtsensoranordnung 4A - 4C ist ein mikrooptisches Element 1A - 1C zugeordnet, nämlich die erste Lichtsensoranordnung 4A dem ersten mikrooptischen Element 1A, die zweite Lichtsensoranordnung 4B dem zweiten mikrooptischen Element 1B und die dritte Lichtsensoranordnung 4C dem dritten mikrooptischen Element 1C. Dabei ist in Fig. 1B das jeweils zugeordnete mikrooptische Element direkt über der jeweiligen Lichtsensoranordnung angeordnet. Abhängig von der Anwendung kann der Durchmesser bzw. die Breite der mikrooptischen Elemente 1A - 1C größer oder kleiner als die laterale Ausdehnung der zugeordneten Lichtsensoranordnung 4A - 4C sein, und direkt darüber angeordnet sein oder nur teilweise direkt darüber angeordnet sein. Ebenfalls ist eine regelmäßige Anordnung der Lichtsensorelemente über dem gesamten Lichtsensor möglich, wie dies in herkömmlichen Bildsensoren der Fall ist.

Die mikrooptischen Elemente 1A - 1C sind derart strukturiert, dass Lichtbündel, die aus unterschiedlichen Richtungen auf die mikrooptischen Elemente 1A - 1C treffen, auf unterschiedliche Lichtsensorelemente 4a - 4e der darunter angeordneten und diesen zugeordneten Lichtsensoranordnungen 4A - 4C gelenkt werden. Oder in anderen Worten, die mikrooptischen Elemente 1A - 1C sind derart über den ihnen zugeordneten Lichtsensoranordnungen 4A - 4C angeordnet und derart optisch strukturiert, dass ein Lichtbündel aus einer ersten Richtung 9A - 9C auf ein erstes Lichtsensorelement 4b der jeweiligen Lichtsensoranordnungen 4A - 4C gelenkt wird, und ein Lichtbündel aus einer zweiten von der ersten Richtung unterschiedlichen Richtung 10A - 10C auf ein zweites von dem ersten Lichtsensorelement unterschiedliches Lichtsensorelement 4c der jeweiligen Lichtsensoranordnungen 4A - 4C gelenkt wird. Dabei beziehen sich die Einfallswinkel nicht auf die sphärische Oberfläche der linsenartigen mikrooptischen Elemente 1A - 1C, sondern auf eine von der jeweiligen räumlichen Strukturierung der mikrooptischen Elemente unabhängigen Oberflächenebene 21, die parallel zu der lateralen Ausdehnung der Wafer 2 und 3 verläuft.

Die Genauigkeit der Auflösung, oder in anderen Worten, die Größe der so pro Lichtsensoranordnung 4A unterscheidbaren Lichteinfallswinkelbereiche 9A und 10A, hängt von der Anzahl der Lichtsensorelemente der Lichtsensoranordnung und der optischen Eigenschaften den mikrooptischen Elements 1A ab, wobei die optischen Eigenschaften einer mikrooptischen sphärischen Linse 1A, wie sie in Fig. 1A dargestellt ist, von dem Durchmesser und der Dicke der Linse, der Krümmung der Linse und der Dicke des Glaswafers 2 abhängt.

Ein Vergleichsbeispiel gemäß Fig. 1A kann daher auch als ultradünner Bildsensor-Wafer 3, der mit einem Mikrooptik-Wafer 2 gebondet ist, bezeichnet werden.

Fig. 1B zeigt eine Aufsicht eines Vergleichsbeispiel gemäß Fig. 1A, wobei der Querschnitt A-A' in Fig. 1B dem in Fig. 1A dargestellten Querschnitt entspricht. Fig. 1B zeigt ein Vergleichsbeispiel mit sphärischen Linsen als mikrooptische Elemente 1A - 1C. In Bezug auf das mikrooptische Element 1B sind zudem die Lichtsensorelemente 4a - 4e aus Fig. 1A dargestellt, wobei lediglich die Lichtsensorelemente 4a und 4e mit Bezugzeichen versehen sind. Wie aus Fig. 1B ersichtlich, können Vergleichsbeispiele Lichtsensoranordnungen 4A - 4C aufweisen, die nicht nur eine Reihe von Lichtsensorelementen 4a - 4e aufweisen, sondern mehrere parallele Reihen oder beliebige Anordnungen von Lichtsensorelementen. Ferner können Vergleichsbeispiele der Waferstapelteile 100 statt der drei mikrooptischen Elemente und der diesen drei zugeordneten Lichtsensoranordnungen 4A - 4C, wie in Fig. 1A im Querschnitt dargestellt, ein mikrooptisches Element oder eine beliebige Anzahl von mikrooptischen Elementen und diesen zugeordneten Lichtsensoranordnungen aufweisen. Dabei können die Waferstapelteilstücke lediglich eine einzelne Reihe von'mikrooptischen Elementen und diesen zugeordneten Lichtsensoranordnungen aufweisen oder mehrere Reihen mit der gleichen Anzahl oder unterschiedlichen Anzahlen von mikrooptischen Elementen und diesen zugeordneten Lichtsensoranordnungen.

Fig. 1C zeigt eine Aufsicht für ein Vergleichsbeispiel eines Waferstapelteilstücks mit zylindrischen Linsen als mikrooptischen Elementen 1A - 1C, wobei wiederum der Querschnitt A-A' in Fig. 1C dem in Fig. 1A gezeigten Querschnitt des Waferstapelteilstücks entspricht. Vergleichsbeispiele des Waferstapelteils können eine beliebige Anzahl von zylindrischen Linsen oder anderen mikrooptischen Elementen 1A - 1C und diesen zugeordneten Lichtsensoranordnungen 4A - 4C aufweisen, und die jeweiligen Lichtsensoranordnungen 4A - 4C statt der fünf in einer Reihe angeordneten Lichtsensorelemente eine beliebige Vielzahl von Lichtsensorelementen in einer Reihe, in mehreren Reihen oder in anderen Anordnungen aufweisen.

Mikrooptische Elemente können beispielsweise in gitterförmigen Anordnungen von Linsen oder anderen mikrooptischen Elementen vorliegen, die den Projektionsstrahl eines Kamerasystems in einzelne Lichtbündel aufteilen, welche wiederum lokale Abbildungen auf dem Bildsensor erzeugen. Eine Anwendungen ist die so genannte Lichtfeld-Fotografie oder integrale Fotografie. Diese erlaubt es, aus Teilbildern das vollständige Bild in verschiedener Weise zu extrahieren. Beispielsweise kann in einem durch die Abbildungsleistung des Kamerasystems begrenzten Rahmen die Tiefeninformation des aufgenommenen Szenarios ausgewertet werden oder eine perspektivische Veränderung im Sinne eines Blickwinkelwechsels vorgenommen werden. Vergleichsbeispiele können neben oder anstelle von Linsen und Prismen als refraktive mikrooptische Elemente 1A - 1C ebenso Anordnungen diffraktiver Optiken als mikrooptische Elemente 1A - 1C aufweisen, die das einfallende Licht anhand von Beugungseffekten räumlich modulieren, beispielsweise um eine spektrale Zerlegung von Lichtstrahlen auf einzelne Sensorelemente vorzunehmen. Ferner müssen die Anordnungen der mikrooptischen Elemente nicht zwangsläufig die Form von Gittern, insbesondere gleichmäßigen Gittern, haben, sondern können beispielsweise auch konzentrisch um einen Mittelpunkt gruppiert sein, ein verzerrtes Gitter bilden, sich nur auf eine Reihe beschränken oder nur über Teilbereiche des Bildsensors verteilt sein. Auch eine zufällig gewählte Verteilung ist möglich. Ferner ist der Begriff "Linsen" im weiteren Sinne der Optik zu verstehen, d. h. refraktive Eigenschaften der mikrooptischen Elemente können durch die Krümmung von Oberflächen, wie sie in Fig. 1A gezeigt ist, erzielt werden, genauso wie durch graduelle Veränderungen des Brechungsindex im Linsenmaterial bzw. in dem Glaswafer 2 oder allgemein in dem zweiten Waferteilstück 2.

In Bezug auf die Herstellung der Waferstapel und Waferstapelteile können zwei grundlegende Vergleichsbeispiele der Prozessfolge unterschieden werden, die im Folgenden kurz erläutert werden.

Bei dem ersten grundlegenden Vergleichsbeispiel liegt der Sensorwafer 3 als vollständig funktionalisierter Wafer vor und wird mit dem zweiten Wafer 2 durch Bonding verbunden. Der Glaswafer 2 kann schon optisch strukturiert sein, in anderen Worten, die mikrooptischen Elemente aufweisen, oder noch unstrukturiert sein, also beispielsweise nur in Form des dafür gedachte Substrats, hier Glassubstrats, vorliegen. Mit vollständig funktionalisierter bzw. fertig prozessierter Wafer 3 wird hier beispielsweise der Bildsensor-Wafer 3 bezeichnet, der schon die in dem Halbleitermaterial 3a erzeugten Halbleiterstrukturen der Lichtsensorelemente 4a - 4e aufweist. Hier scheiden Verfahren mit hoher Temperatureinwirkung aus, um die schon erzeugten Halbleiterstrukturen und Metallisierungsebenen nicht zu zerstören, so dass in solchen Vergleichsbeispielen Waferbondingverfahren eingesetzt werden, die hohe Temperaturen vermeiden, also z. B. adhäsives Bonding. Dies gilt entsprechend für teilweise funktionalisierte bzw. teilweise prozessierte Wafer, in denen zumindest teilweise die Halbleiterstrukturen schon erzeugt sind oder andere temperatursensitive Strukturen erzeugt sind.

In anderen Worten, bei Vergleichsbeispielen des Herstellungsverfahrens, bei denen der Bildsensor-Wafer 3 vor dem Bonden fertig strukturiert wird, z. B. wie in Fig. 1A mit den entsprechenden Lichtsensoranordnungen 4A - 4C und den entsprechenden Lichtsensorelementen sowie den Leiterstrukturen 5a und 5b, kann vor dem Bonden auch der Glaswafer 2 fertig strukturiert sein, also beispielsweise die mikrooptischen Elemente 1a - 1c aufweisen, oder noch unstrukturiert oder nur teilweise strukturiert sein, wobei die optische Strukturierung des Glaswafers 2 nach dem Waferbonden erfolgt.

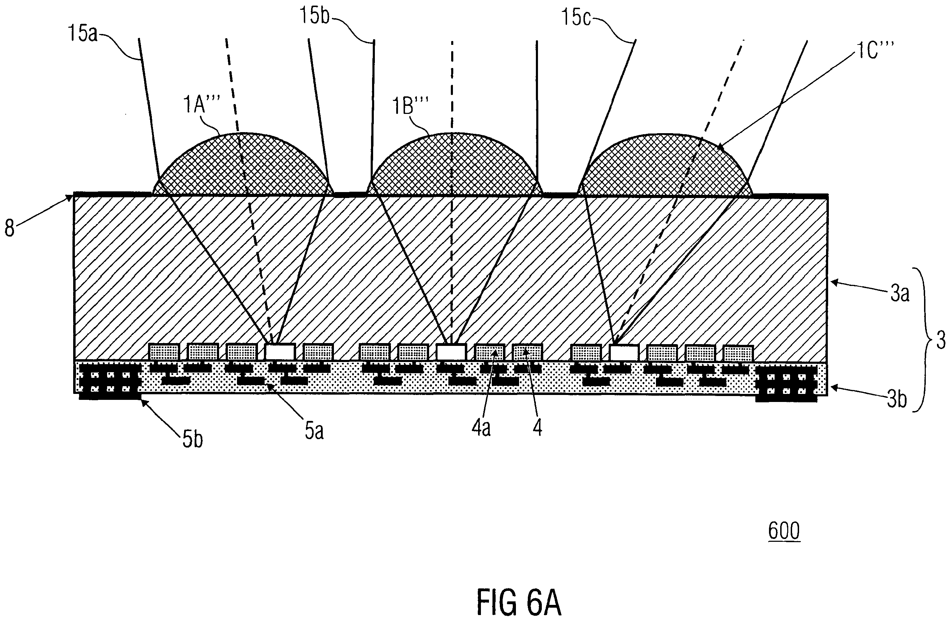

In alternativen Vergleichsbeispielen, bei denen im Wesentlichen infrarotes Licht gemessen wird, und damit eine Infrarotoptik eingesetzt wird, wie dies beispielsweise anhand von Fig. 6A noch näher beschrieben wird, oder in Vergleichsbeispielen mit diffraktiver Optik, kann das Material des Sensorwafers 2 auch in optische Elemente umgeformt oder entsprechend strukturiert werden.

Bei dem zweiten grundlegenden Vergleichsbeispiel erfolgt die Verbindung bzw. das Bonden des Mikrooptik-Wafers 2 bzw. dessen Vorstufe, z. B. eines Borsilikat-Glaswafers, mit dem Siliziumkristall des Sensorwafers 3 vor dessen eigentlicher Herstellung, so dass anodisches Bonden oder Silizium-Direktbonden zum Einsatz kommen kann. Auch die Formung der mikrooptischen Elemente 1A - 1C kann bei bestimmten Vergleichsbeispielen, z. B. Mikrolinsen 1A - 1C geringer Höhe oder konkaven Linsen, schon in diesem Schritt erfolgen. Insbesondere kann bei derartigen Vergleichsbeispielen der Mikrooptik-Wafer 2 als Träger für den Sensorwafer 3 dienen, um diesen auf eine sehr geringe Dicke herunterzuschleifen.

Derartige Verfahren sind für die Herstellung der sogenannten "SOI-Wafer" (silicon on insulator - SOI) bekannt.

Gemäß einem Vergleichsbeispiel dieses zweiten grundlegenden Vergleichsbeispiels sind sowohl der erste Wafer aus Halbleitermaterial als auch der zweite Wafer aus transparentem Material unprozessiert bzw. unstrukturiert und können durch anodisches Bonden verbunden werden. In einem weiteren Vergleichsbeispiel des zweiten grundlegenden Vergleichsbeispiels ist lediglich der erste Wafer aus dem Halbleitermaterial unprozessiert, während der Wafer aus dem transparenten Material schon teilweise oder fertig optisch strukturiert ist. Auch in diesem Fall kann anodisches Bonden angewendet werden, wenn die optischen Strukturen in dem transparenten Wafer nicht beschädigt werden, wie dies beispielsweise bei Glas im Gegensatz zu vielen Kunststoffen der Fall ist.

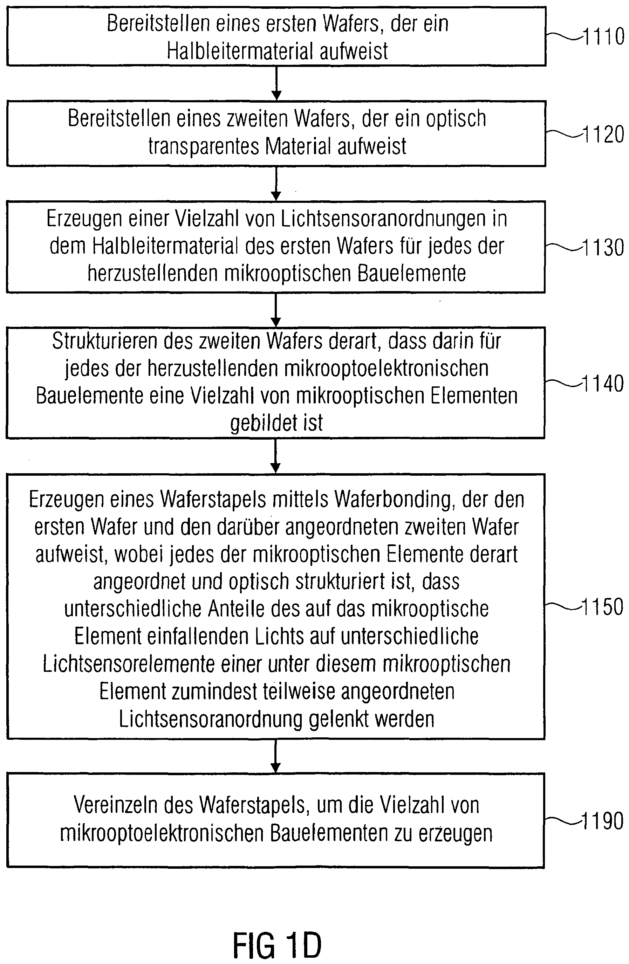

Fig. 1D zeigt ein Flussdiagramm eines Vergleichsbeispiels eines Verfahrens zur Herstellung eines Waferstapels mit einer Vielzahl von mikrooptoelektronischen Bauelementen mit den folgenden Schritten.

Bereitstellen 1110 eines ersten Wafers, der ein Halbleitermaterial aufweist, und Bereitstellen 1120 eines zweiten Wafers, der ein optisch transparentes Material aufweist.

Erzeugen 1130 einer Vielzahl von Lichtsensoranordnungen in dem Halbleitermaterial 3a des ersten Wafers für jedes der herzustellenden mikrooptischen Bauelemente.

Strukturieren 1140 des zweiten Wafers derart, dass darin für jedes der herzustellenden mikrooptoelektronischen Bauelemente 100 eine Vielzahl von mikrooptischen Elementen 1A - 1C gebildet ist.

Erzeugen 1150 eines Waferstapels mittels Waferbonding, der den ersten Wafer und den darüber angeordneten zweiten Wafer aufweist, wobei jedes der mikrooptischen Elemente 1a - 1c derart angeordnet und optisch strukturiert ist, dass unterschiedliche Anteile des auf das mikrooptische Element fallenden Lichts auf unterschiedliche Lichtsensorelemente 4a - 4e einer unter diesem mikrooptischen Element zumindest teilweise angeordneten Lichtsensoranordnung 4a - 4c gelenkt werden.

Vereinzeln 1190 des Waferstapels, um die Vielzahl von mikrooptoelektronischen Bauelementen 100 zu erzeugen. Dabei können die Schritte 1110 und 1120 des Bereitstellens gleichzeitig oder in anderer Reihenfolge durchgeführt werden. Des Weiteren kann der Schritt des Erzeugens 1130 einer Vielzahl von Lichtsensoranordnungen abhängig von der Art des Waferbondings und der Art des Strukurierens des zweiten Wafers vor oder nach dem Erzeugen 1150 des Waferstapels erfolgen, und der Schritt 1140 des Strukturierens des zweiten Wafers abhängig von der Art des Waferbondings vor oder nach dem Schritt des Erzeugens 1150 des Waferstapels erfolgen. Entsprechendes gilt auch für die anderen Vergleichsbeispiele. Der Schritt 1130 zum Erzeugen der Vielzahl von Lichtsensoranordnungen 4a - 4e umfasst beispielsweise die entsprechende Dotierung des Halbleitermaterials, um die Transistorstrukturen zu erzeugen, oder allgemein formuliert, die Erzeugung des ersten Teils 3a des Bildsensor-Wafers 3. Ferner kann der Schritt 1130 auch die Erzeugung des zweiten Teils 3b des Bildsensor-Wafers 3 mit den Verdrahtungsebenen aus Polysilizium und/oder Metallen sowie den isolierenden Bereichen aus Oxiden und/oder Nitriden umfassen.

Als optisch transparentes Material wird vorzugsweise Glas verwendet, es können aber auch andere transparente Materialien, z.B. Kunststoffe, für den zweiten Wafer 2 verwendet werden.

Darüber hinaus wird die Herstellung von Mikrooptiken auf Waferebene vorzugsweise mit Glaswafern 2 realisiert, bei dem das Glas hinsichtlich der thermischen Ausdehnungskoeffizienten an das Halbleitermaterial, z. B. Silizium, angepasst ist. Beispiele für derartige Gläser bzw. Wafermaterialien sind Borsilikat-Gläser oder alkalifreie Glaswafer.

Für den Schritt 1140, das Strukturieren des zweiten Wafers, können verschiedene Verfahren eingesetzt werden. Zum einen kann beispielsweise eine mikrooptische Linsenanordnung aus einer Glasoberfläche ausgeätzt werden, zum anderen kann eine mikrooptische Linsenanordnung mittels Umformen durch viskose Formgebung erfolgen. Dabei fließt das Glas bei entsprechend hoher Temperatur und nimmt die gewünschte Form an. Mittels Umformen hergestellte Mikrooptiken haben gegenüber geätzten Optiken den Vorteil, dass sie typischerweise kostengünstiger hergestellt werden können und auch für die Formung von Gläsern mit angepasster thermischer Ausdehnung geeignet sind.

Andere Verfahren, die in Schritt 1140 zum Strukturieren des zweiten Wafers eingesetzt werden können, sind Grauton-Lithographie und Laser-Ablation. Grautonlithografie bedeutet, dass ein Höhenprofil in eine Resistschicht eingebracht wird und durch anisotropisches Trockenätzen in die zu strukturierende Oberfläche übertragen wird.

Zudem können in Schritt 1140 Diffraktionsmuster oder Beugungsmuster beispielsweise mittels Masken-Lithographie, Elektronenstrahlschreiben, Ionenstrahlschreiben, Laserbelichtung, Laserablation und/oder abrasive Verfahren hergestellt werden.

In weiteren Vergleichsbeispielen werden in Schritt 1140 durch energiereiche Laserstrahlung lokale Veränderungen von Materialeigenschaften innerhalb des zweiten Wafers, z. B. einem Glaswafer, und/oder dem ersten Wafer, z. B. einem Siliziumwafer, erzeugt, die ebenfalls mikrooptische Elemente bilden, die auf diffraktiven und/oder refraktiven Effekten basieren.

Der Schritt 1150 des Waferbondens, das auch als "Wafer-Stacking" im Sinne von "Stapeln von Wafern" durch Bondverfahren bezeichnet wird, kann als Fügeverfahren jede Art von stoffschlüssiger Verbindung umfassen, z. B. Kleben oder Löten, aber auch Effekte wie die Festkörperdiffusion zwischen extrem glattpolierten Flächen nutzen, wie dies beispielsweise bei dem anodischen Bonden und Direktbonden der Fall ist. Geräte zum Positionieren und Fügen von Wafern werden Waferbonder genannt. In Vergleichsbeispielen des Herstellungsverfahrens werden Waferbonder eingesetzt, die die zu verbindenden Wafer bzw. Waferscheiben, im Allgemeinen Silizium und/oder Glas, zunächst zueinander justieren und sie dann je nach der Art des Waferbonding unter Vakuum, Druck und Hitze miteinander verbinden. Die Justagegenauigkeit ist durch optische Verfahren sehr hoch, d. h. im Bereich von etwa 1 $\mu$m. Nach dem Justieren wird dabei jedoch der obere Wafer durch gleichzeitiges Lösen seiner Haltepunkte auf den unteren Wafer fallengelassen, so dass sich daraus unter Umständen geringe weitere Verschiebungen ergeben können. Aber auch unter Berücksichtigung dieser weiteren Verschiebungen können in gut kontrollierten Serienprozessen effektive Toleranzen, die besser als 1 - 2 μm sind, erreicht werden. Da diese am Waferrand eingestellt werden, ist der Rotationsfehler zudem extrem gering.

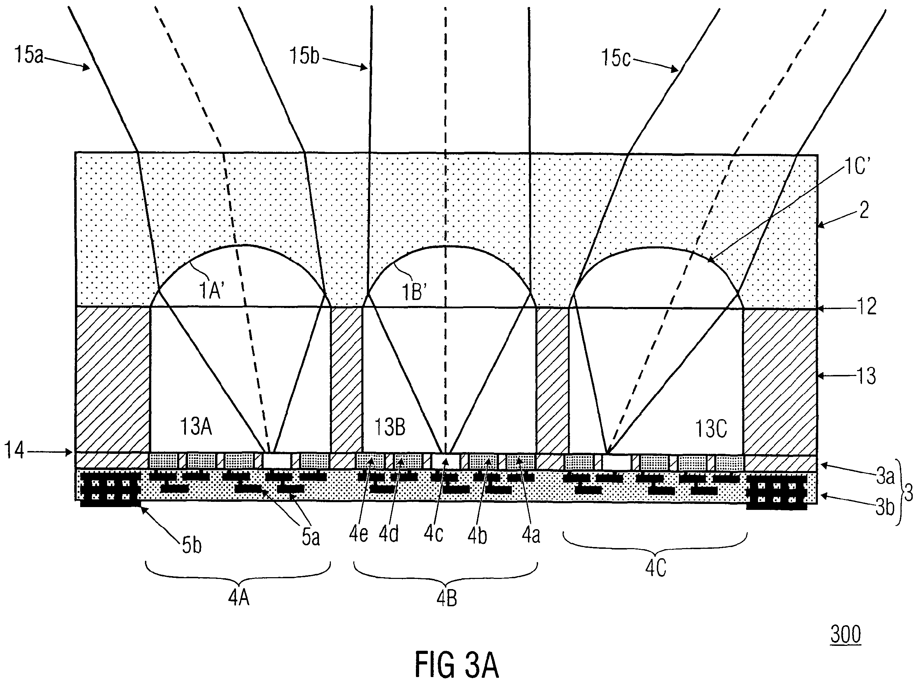

Das Bonden von Wafern mittels Klebstoffen kann beispielsweise angewendet werden, um extrem dünne Wafer herzustellen. Diese werden vor dem Dünnen temporär auf einen anderen Wafer gebondet, einem sogenannten Trägerwafer, der nur zur Handhabung dient und später wieder entfernt wird. Dieses temporäre Bonden ist eine Möglichkeit, dünne Wafer für die Rückseitenbelichtung herzustellen, die ansonsten aufgrund ihrer geringen Dicke allein zu instabil für die Handhabung wären. Bei Vergleichsbeispielen mit einem Stapel aus einem Sensorwafer 3 und einem zweiten transparenten Wafer 2, kann der zweite transparente Wafer, siehe Fig. 1A, und/oder ein zusätzlicher Wafer 13, siehe Fig. 3A, mechanisch so strukturiert sein, z.B. durch eine ausreichende Dicke desselben, dass sehr dünne Sensorwafer 3 für eine Rückseitenbelichtung verwendet werden können, ohne derartige temporäre Träger zu benötigen. Der transparente zweite Wafer 2 und/oder der zusätzliche Wafer 13 können somit zusätzlich zu ihrer optischen Funktion auch eine mechanische Funktion für die Stabilisierung aufweisen.

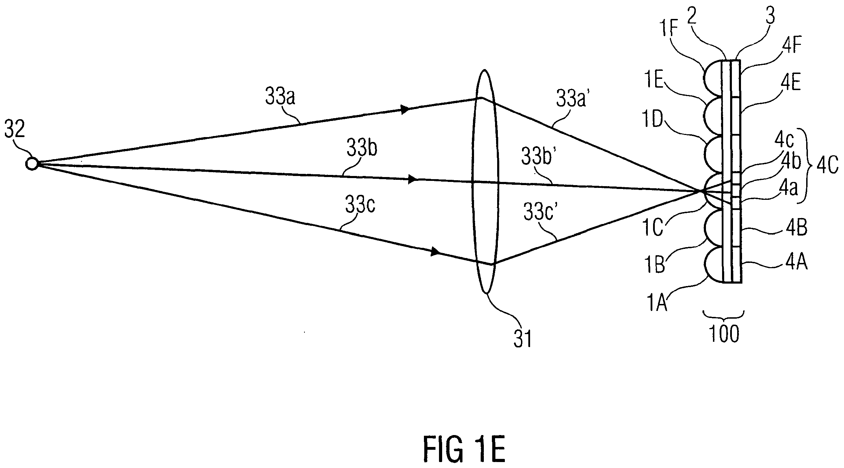

Im Folgenden wird anhand von Fig. 1E ein Vergleichsbeispiel für die Lichtfeld-Fotografie beschrieben. Fig. 1E zeigt eine schematische Darstellung eines Ausführungsbeispiels für eine Lichtfeld-Fotografie mit einer Hauptlinse 31 und einem mikrooptoelektronischen Bauelement 100, das wiederum ähnlich wie in Fig. 1A einen optisch strukturierten Glaswafer 2 mit mikrooptischen Linsenstrukturen 1A - 1F zeigt sowie die diesem zugeordneten Lichtsensoranordnungen 4A - 4F. Um die Darstellung übersichtlich zu halten, wurde auf Details ähnlich zu Fig. 1A verzichtet und in Fig. 1E auch nur drei Lichtsensorelemente 4a - 4c für die Lichtsensoranordnung 4C eingezeichnet. In Fig. 1E sind ferner eingezeichnet ein Punkt 32 eines Objekts sowie drei beispielhafte Strahlengänge 33a - 33c, die von dem Objekt 32 ausgehend auf die Hauptlinse 31 treffen, dort gebrochen werden und als jeweils gebrochene Strahlen 33a' - 33c' auf das mikrooptische Element 1C treffen, und dort wiederum gebrochen werden, und auf die Lichtsensorelemente 4a - 4c treffen. Dabei bilden die Strahlen 33a' - 33c' Beispiele für die Lichtbündel 9C und 10C aus Fig. 1A, die aus verschiedenen Richtungen auf die mikrooptische Linse 1C treffen, und dort abhängig von ihrer Einfallsrichtung bzw. ihrem Einfallswinkel auf verschiedene Lichtsensorelemente gelenkt werden.

Allgemein ausgedrückt werden die Lichtstrahlen von dem Punkt 32 eines Objekts durch die Hauptlinse 31 auf einen Punkt der Brennebene des mikrooptoelektronischen Bauelements 100 gelenkt. Im Gegensatz zu einer normalen Fotografie, bei dem hinter der Hauptlinse kein Mikrolinsenfeld 1A - 1F angeordnet ist, und lediglich die Gesamtlichtintensität der Lichtstrahlen 33a' - 33c' aufgenommen wird, werden die Lichtstrahlen 33a' - 33c' durch die zusätzliche mikrooptische Linse 1C gebrochen, so dass nicht nur die Intensität, sondern die Teilintensitäten abhängig von deren Einfallswinkel erfasst werden. Diese zusätzlichen Informationen können beispielsweise für die Erzeugung von dreidimensionalen Aufnahmen verarbeitet werden.

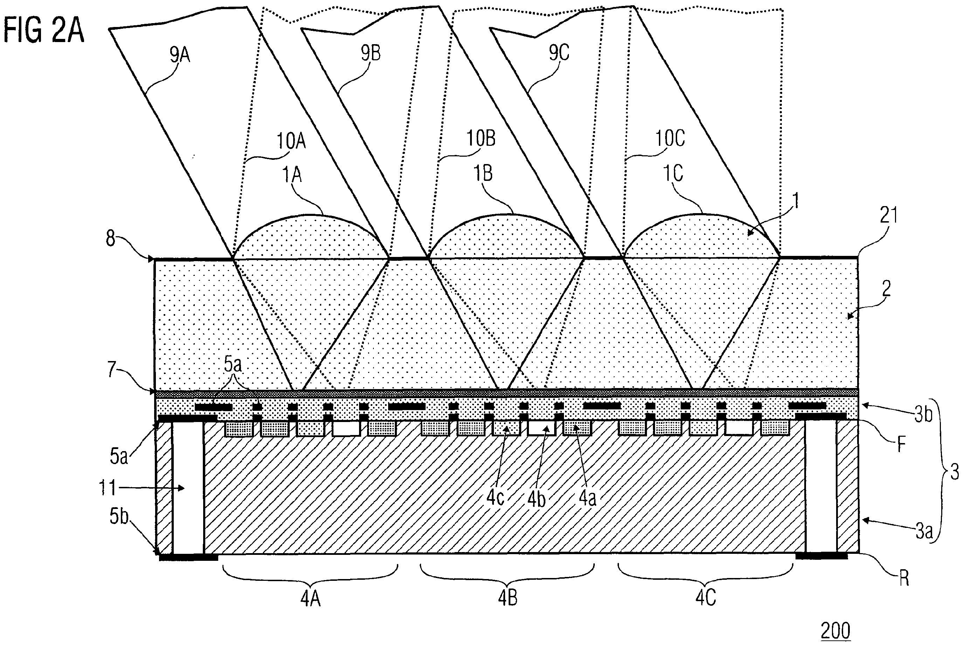

Fig. 2A zeigt ein Waferstapelteilstück 200, das dem von Fig. 1A ähnlich ist, sich jedoch von diesem dadurch unterscheidet, dass der Bildsensor-Wafer 3 für eine Vorderseitenbelichtung ausgebildet ist. In anderen Worten, die Lichtsensoranordnungen 4A - 4C sind an der Vorderseite F des Bildsensor-Wafers 3 bzw. des Halbleitermaterialteils 3a angeordnet, und darüber der Verdrahtungsebenenteil 3b mit den verborgenen Verbindungsebenen 5a und den außenliegenden Kontaktflächen 5b. Wie aus Fig. 2A ersichtlich, sind die verborgenen bzw. innenliegenden Verbindungsebenen 5a in Bezug auf den Lichteinfall nicht hinter den Lichtsensorelementen 4a - 4c, sondern, wie zuvor beschrieben, seitlich davon angeordnet. Die Verbindungsebenen 5a werden durch elektrische Durchführungen 11 in dem Bildsensor-Wafer 3a mit den Kontaktflächen 5b elektrisch verbunden, um diese an externe Schaltkreise anzuschließen. Daneben oder zusätzlich können derartige Durchführungen 11 auch in dem Mikrooptik-Wafer 2 gebildet werden, wobei dann eine Öffnung in der Adhäsionsschicht 7 belassen oder gebildet werden muss. Um die prozesstechnisch komplexen Durchkontaktierungen 11 zu vermeiden, kann auch ein Fenster für die Kontakte auf dem Sensorwafer 3 geöffnet werden. Dies kann im Mikrooptik-Wafer 2 beispielsweise durch besondere Sägeverfahren oder durch ein großflächiges Aufätzen erfolgen.

Wie im direkten Vergleich zwischen Fig. 1A und 2A ersichtlich, ist das Waferstapelstück 200 dicker als das aus Fig. 1A.

Das Herstellungsverfahren für derartige mikrooptische Bauelemente 200 ähnelt dem Verfahren gemäß Fig. 1D und unterscheidet sich im Wesentlichen dadurch, dass die Lichtsensorelemente 4a - 4c auf der Vorderseite F des Halbleiterteils 3a erzeugt werden, der Verbindungsstrukturteil 3b auf der Vorderseite F des Halbleitermaterialteils 3a gebildet wird und der Glaswafer 2 und der Bildsensor-Wafer 3 an der dem Halbleitermaterialteil 3a abgewandten bzw. gegenüberliegenden Oberfläche des Verdrahtungsteils 3b erfolgt.

Aufgrund der größeren Dicke des Halbleitermaterialteils 3a und damit des Bildsensor-Wafers 3 kann der Bildsensor-Wafer 3 schon allein eine ausreichende Stabilität aufweisen, so dass bei derartigen Beispielen auch sehr dünne Glaswafer 2 eingesetzt werden können.

Fig. 3A zeigt einen Querschnitt eines Waferstapelteilstücks 300 mit einem Bildsensor-Wafer 3 für eine Rückseitenbelichtung, wie in Fig. 1A beschrieben, der jedoch im Gegensatz zu Fig. 1A keine Linsenstrukturen 1A bis 1C auf der dem Lichteinfall 15a - 15c zugeordneten Oberfläche aufweist, sondern auf der dem Bildsensor-Wafer 3 zugeordneten Seite konkave mikrooptische Elemente 1A' - 1C' aufweist. Zwischen dem Bildsensor-Wafer 3 und dem Glaswafer 2 ist ein weiterer Wafer 13 bzw. ein weiteres Waferteilstück 13 angeordnet, das Kavitäten 13A - 13C, die auch als Durchgangsöffnungen bezeichnet werden können, aufweist. Die Kavitäten 13A - 13C sind in dem zusätzlichen Waferstück 13 über den entsprechenden Lichtsensoranordnungen 4A - 4C angeordnet, so dass Licht durch die konkaven mikrooptischen Strukturen 1A' - 1C' gebrochen wird und durch die Kavitäten 13A - 13C hindurch auf die Lichtsensoranordnungen 4A - 4C trifft.

In Fig. 3A sind drei Lichtbündel 15a - 15c gezeigt, die jeweils aus verschiedenen Richtungen auf das Glaswaferteilstück 2 auftreffen, analog zu den Strahlen 9A - 9C und den Lichtstrahlen 10A - 10C aus Fig. 1A, jedoch sind hier der Übersichtlichkeit halber nur stellvertretend drei einzelne Strahlen aus jeweils verschiedenen Richtungen eingezeichnet. Wie schon in Fig. 1A beschrieben, wird der Lichtstrahl 15a, der aus einer ersten Richtung auf das Glaswaferteilstück 2 auftrifft, durch die erste konkave mikrooptische Struktur 1A' derart gebrochen und gebündelt, dass dieser auf das Lichtsensorelement 4b der Lichtsensoranordnung 4A fällt. Das zweite Lichtbündel 15b, das aus einer zweiten von der ersten Richtung unterschiedlichen Richtung auf das Glaswaferteilstück fällt, wird durch die konkave mikrooptische Struktur 1B' derart gebrochen und gebündelt, dass dieser auf das Lichtsensorelement 4c der Lichtsensoranordnung 4B fällt. Das dritte Lichtbündel 15c fällt aus einer dritten Richtung, die unterschiedlich von den ersten zwei Richtungen ist, auf das Glaswaferteilstück 2 und wird dort durch die konkave mikrooptische Struktur 1C' derart gebrochen und gebündelt, dass dieses auf das Lichtsensorelement 4d der Lichtsensoranordnung 4C fällt.

Die Kavitäten 13A - 13C können mit Flüssigkeiten oder Gasen gefüllt sein, vorzugsweise jedoch mit Gasen, z.B. Luft, aufgrund des geringeren Brechungsindex. Alternativ kann auch ein Vakuum in den Kavitäten 13A - 13C vorliegen.

Das Bezugszeichen 12 bezeichnet die Fügezone zwischen dem Mikrooptik-Wafer 2 bzw. Glaswaferteilstück 2 und dem zusätzlichen Waferteilstück 13, der beispielsweise ein Siliziumwafer 13 ist. Die Verwendung von Wafern 3 bzw. 3a und 13, die die gleichen bzw. ähnliche Materialien aufweisen vereinfacht das Bonden und die Herstellung allgemein. Der zusätzliche Wafer 13 kann jedoch auch andere Halbleitermaterialien oder andere nichttransparente Materialien aufweisen. Waferteilstücke 13 aus einem nichttransparenten Material haben den Vorteil, dass Störungen durch Streulicht, die in Fig. 1A durch die zusätzliche lichtundurchlässige Schicht 8 reduziert werden, auch hier gering gehalten werden können. Das Bezugszeichen 14 bezeichnet die Fügezone zwischen dem Bildsensor-Wafer 3, der beispielsweise auch ein Siliziumwafer 3 sein kann, und dem zusätzlichen Waferteilstück 13. Die Fügezone 14 kann auch eine Oxidschicht aufweisen.

Beispiele 300 können mit der Technik der viskosen Abformung von Mikrolinsen hergestellt werden. Dabei wird beispielsweise ein Siliziumwafer 13 mit Kavitäten 13A - 13C versehen, z. B. durch ein anisotropes ionengestütztes Ätzverfahren, ein anisotropes Naßätzverfahren oder ein isotropes Naßätzverfahren. Der Glaswafer 2 wird anodisch auf das Silizium 13 gebondet und die Kavitäten 13A - 13C durch einen weiteren Siliziumwafer 3 verschlossen, z. B. durch anodisches oder direktes Bonden. Durch hohe Temperatur und die Druckdifferenz zwischen den Kavitäten und der Umgebung findet dann die Formgebung der konkaven Linsenstrukturen 1A' - 1C' statt.

Der Waferstapel aus den drei Wafern 3, 13 und 2 wird danach so bearbeitet, dass er als Ausgangsmaterial für die Herstellung der Funktionsstrukturen des Bildsensor-Wafers 3 verwendet werden kann, beispielsweise Dünnen auf eine handhabbare Waferdicke und Polieren zum Erreichen der erforderlichen Oberflächenqualität.

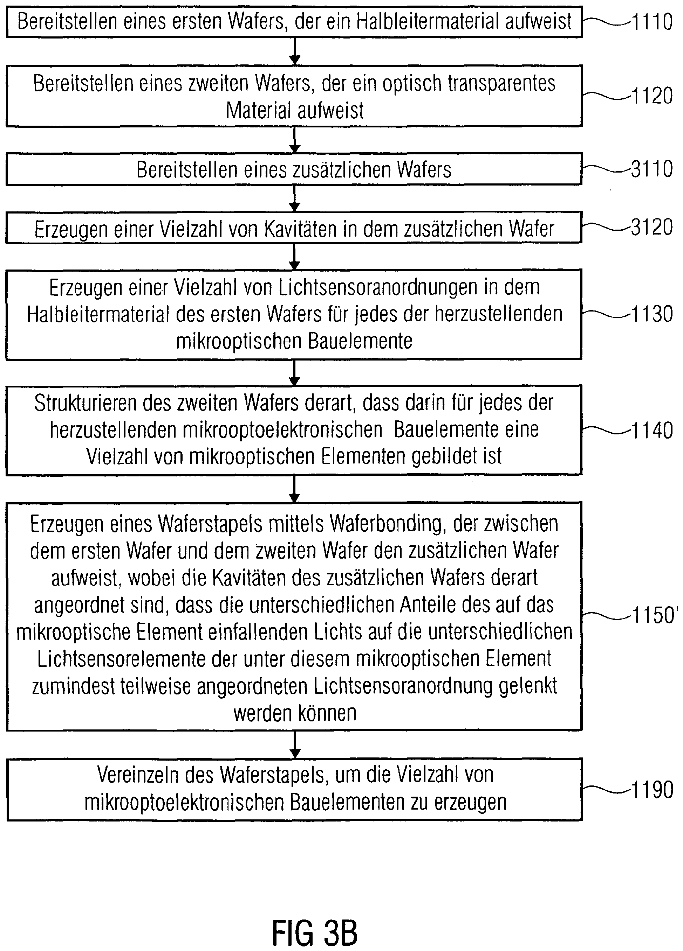

Fig. 3B zeigt ein Flussdiagramm eines Verfahrens zur Herstellung eines Waferstapels mit einer Vielzahl von mikrooptoelektronischen Bauelementen, das im Vergleich zu dem aus Fig. 1D die folgenden zusätzlichen Schritte aufweist.

Bereitstellen 3110 eines zusätzlichen Wafers, z.B. aus einem Halbleitermaterial, vorzugsweise aus demselben Material wie das Substrat 3a. Das Material ist vorzugsweise ferner lichtundurchlässig bzw. nicht transparent.

Erzeugen 3120 einer Vielzahl von Kavitäten 13A - 13C in dem zusätzlichen Wafer.

Erzeugen 1150' eines Waferstapels mittels Waferbonding, der zwischen dem ersten Wafer 3 und dem zweiten Wafer 2 den zusätzlichen Wafer 13 aufweist, wobei die Kavitäten 13A - 13C des zusätzlichen Wafers 13 derart angeordnet sind, dass die unterschiedlichen Anteile 15a - 15c des auf das mikrooptische Element 1A' - 1C' einfallenden Lichts auf die unterschiedlichen Lichtsensorelemente 4a - 4e der unter diesem mikrooptischen Element zumindest teilweise angeordneten Lichtsensoranordnung 4A - 4C gelenkt werden können.

Der Schritt des Erzeugens 1130 der Vielzahl von Lichtsensoranordnungen kann abhängig von der Art des Erzeugens der Kavitäten vor oder nach dem Schritt des Erzeugens 3120 der Kavitäten erfolgen.

Ein Beispiel gemäß Fig. 3A kann auch als Mikrooptik-Wafer 2, 13 mit Kavitäten 13A - 13C auf einem Bildsensor-Wafer 3 bezeichnet werden, der Fügezonen 12 und 14 aufweist und vor dem CMOS-Prozess zur Herstellung der Funktionsstrukturen des Bildsensor-Wafers 3 gebondet wurde.

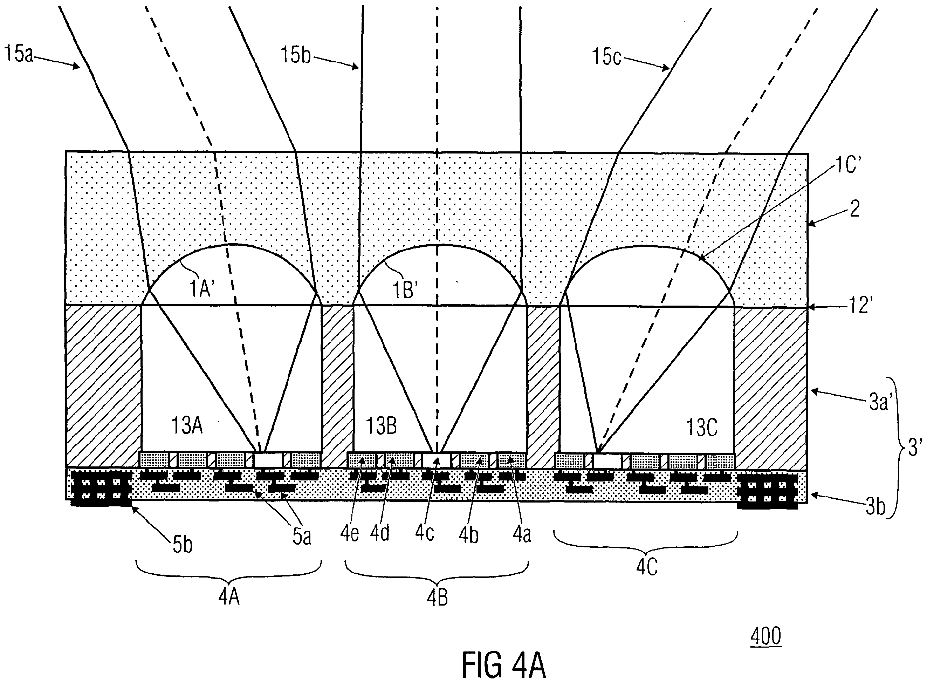

Fig. 4A zeigt ein weiteres Beispiel 400 eines Waferstapelteilstücks, das dem aus Fig. 3A sehr ähnelt, bei dem jedoch im Gegensatz zu dem aus Fig. 3A die Kavitäten 13A - 13C direkt in das Substrat des Sensorwafers 3 bzw. genauer in das Substrat des Halbleiterteils 3a (der auch als Substratteil 3a bezeichnet werden kann) geätzt wurden. Um diesen strukturellen Unterschied gegenüber Fig. 3A hervorzuheben, wird der Halbleitermaterialteil 3a hier mit 3a' bezeichnet, der Bildsensor-Wafer mit 3' und die Fügezone zwischen dem Bildsensor-Wafer 3' und dem Glaswafer 2 mit 12' (Siliziumwafer 3' mit eingearbeiteten Kavitäten, 12': Fügezone zwischen Siliziumwafer 3' und Glaswafer 2, kann auch eine Oxidschicht enthalten; Strahlenbündel 15a - 15c mit fokaler Hilfslinie, siehe gestrichelte Linie).

Die Herstellung derartiger Beispiele erfordert eine sehr homogene Kontrolle der Ätztiefe. Dabei kann die Herstellung der Kavitäten 13A - 13C vor oder nach der Prozessierung des Bildsensor-Wafers 3' erfolgen. Erfolgt sie vorher, so können auch die Linsen 1A' - 1C' vorher geformt werden. Erfolgt sie danach, wird beispielsweise ein mit Linsen 1A' - 1C' strukturierter Glaswafer 2 aufgesetzt, da das viskose Fließen der Linsen erst oberhalb der zulässigen Temperatur für funktionale Halbleiterbauelemente beginnt. Bei diffraktiven Optik-Elementen können andere Randbedingungen herrschen.

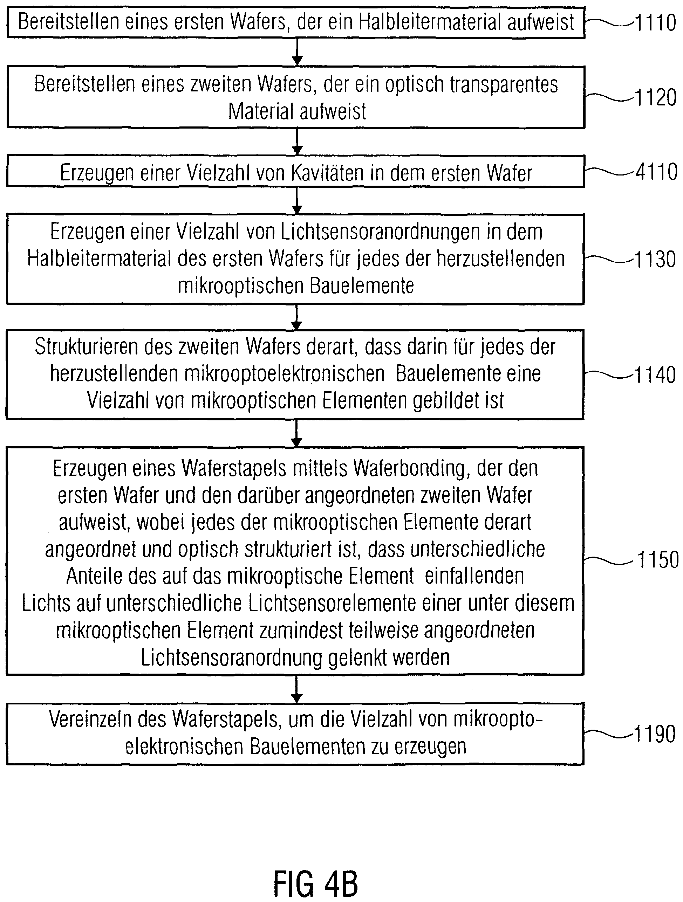

Beispiele gemäß Fig. 4 können auch kurz als Mikrooptik-Wafer 2 mit Kavitäten 13A - 13C als integraler Bestandteil des Bildsensor-Wafers 3' bezeichnet werden, wobei das Bonden vor dem CMOS-Prozess erfolgte.

Fig. 4B zeigt ein Flussdiagramm eines Verfahrens zur Herstellung eines Waferstapels mit einer Vielzahl von mikrooptoelektronischen Bauelementen, das im Vergleich zu dem aus Fig. 1D die folgenden zusätzlichen Schritte aufweist.

Erzeugen 4110 einer Vielzahl von Kavitäten 13A - 13C in dem ersten Wafer 3 und auf der Rückseite desselben, wobei die Kavitäten 13A - 13C des ersten Wafers 3 derart angeordnet sind, dass die unterschiedlichen Anteile 15a - 15c des auf das mikrooptische Element 1A' - 1C' einfallenden Lichts auf die unterschiedlichen Lichtsensorelemente 4a - 4e der unter diesem mikrooptischen Element zumindest teilweise angeordneten Lichtsensoranordnung 4A - 4C gelenkt werden können. Der Schritt des Erzeugens 1130 der Vielzahl von Lichtsensoranordnungen kann abhängig von der Art des Erzeugens der Kavitäten und der Art des Waferbonding der Wafer 2,3, 13 vor oder nach dem Schritt des Erzeugens 4110 der Kavitäten und/oder vor oder nach dem Waferbonden erfolgen.

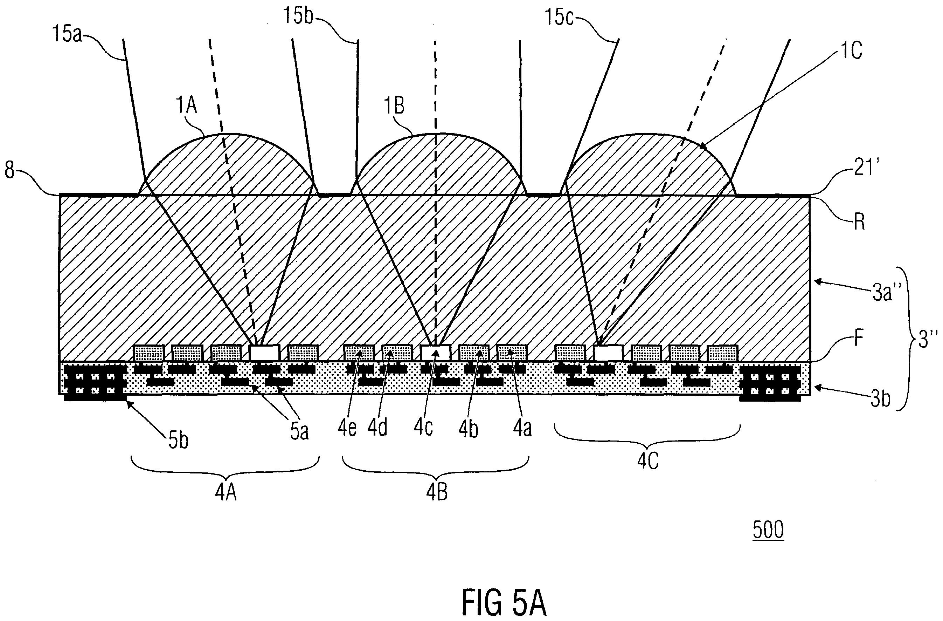

Fig. 5A zeigt ein weiteres Beispiel 500 eines Waferteilstücks, bei dem der Sensorwafer 3", genauer gesagt der Halbleiterteil 3a", das Grundmaterial bildet, aus dem die Mikrooptik-Strukturen 1A - 1C herausgearbeitet werden, z. B. durch einen rückseitigen Ätzangriff, eine lithographisch hergestellte Struktur oder lokale Materialveränderungen wie Dotierung, Diffusion oder Oxidation. In anderen Worten, der Bildsensor-Wafer 3" selbst wird optisch strukturiert. Beispiele 500 können daher auch kurz als mikrooptoelektronische Bauelemente bzw. Waferteilstücke bezeichnet werden, bei denen die Mikrooptik 1A - 1C integraler Bestandteil des Sensorwafers 3" ist. Die erste Schicht 3a" ist hier beispielsweise ein Siliziumsubstrat, das im Infrarotbereich transparent ist. Damit kann das Halbleitermaterial selbst für refraktive Optiken verwendet werden oder als Substrat für Optik-Elemente dienen. Insofern ist es bei derartigen Beispielen, die im infraroten Licht betrieben werden sollen, ausreichend, wenn nur deren Rückseiten R optisch strukturiert werden. Des Weiteren können die Wafer aus Stabilitätsgründen eine entsprechende Dicke aufweisen, ohne dass dadurch im verwendeten Lichtwellenlängenbereich die Transparenz des Wafers 3" beeinträchtigt wird.

Analog zu Fig. 1A ist zusätzlich eine strukturierte, lichtundurchlässige Schicht 8 zur Vermeidung von infrarotem Streulicht auf die Rückseite R des Bildsensor-Wafers 3" aufgebracht. Für die einfallenden Lichtbündel 15a - 15c, die aus verschiedenen Richtungen auf die Oberfläche 21' der Rückseite des Bildsensor-Wafers 3" fallen, die Brechung und Fokussierung durch die konvexen mikrooptischen Strukturen 1A - 1C sowie die Fokussierung auf verschiedene Bildsensorelemente 4a - 4e abhängig von der jeweiligen Lichteinfallsrichtung, wird auf die vorhergehenden Ausführungen verwiesen.

Die Technologien, die zur Detektion von infrarotem Licht eingesetzt werden, sind teilweise nicht mit der CMOS-Technologie verwandt und sind beispielsweise als MEMS-Bolometer (MEMS - mikroelektromechanische Systeme) bekannt. Die Darstellungsweise der Pixel 4a - 4e und der Verdrahtungsebene 5a ist deshalb hier nur symbolisch zu verstehen.

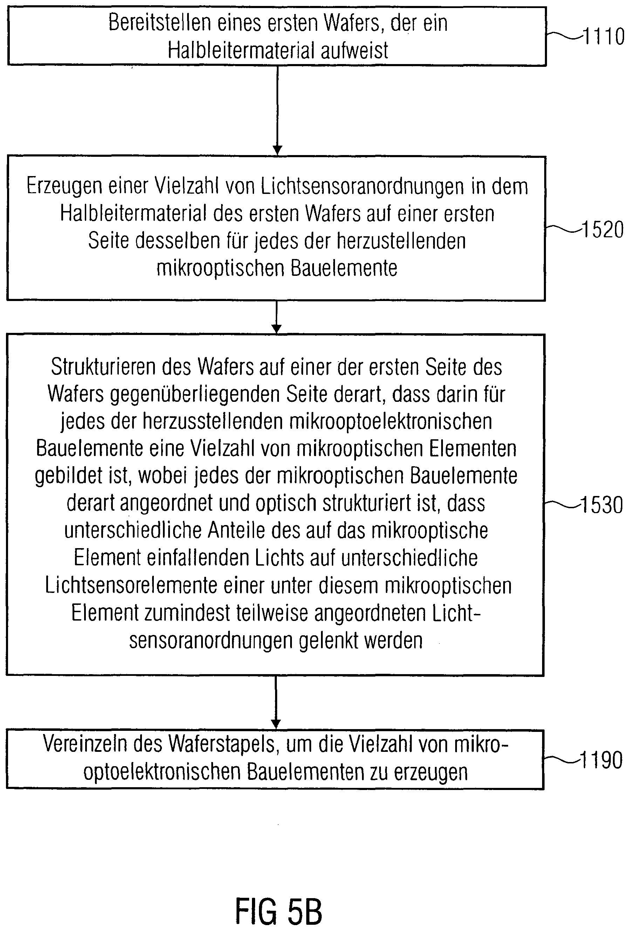

Fig. 5B zeigt ein Flussdiagramm eines Verfahrens zur Herstellung eines Wafers mit einer Vielzahl von mikrooptoelektronischen Bauelementen mit den folgenden Schritten.

Bereitstellen 1110 eines Wafers, der ein Halbleitermaterial aufweist.

Erzeugen 1520 einer Vielzahl von Lichtsensoranordnungen 4A - 4C in dem Halbleitermaterial 3a" des Wafers 3" auf einer ersten Seite (Vorderseite) F desselben für jedes der herzustellenden mikrooptoelektronischen Bauelemente.

Strukturieren 1530 des Wafers 3" auf einer der ersten Seite des Wafers gegenüberliegenden Seite (Rückseite) R derart, dass darin für jedes der herzustellenden mikrooptoelektronischen Bauelemente eine Vielzahl von mikrooptischen Elementen 1a - 1c gebildet ist, wobei jedes der mikrooptischen Bauelemente 1A - 1C derart angeordnet und optisch strukturiert ist, dass unterschiedliche Anteile des auf das mikrooptische Element einfallenden Lichts auf unterschiedliche Lichtsensorelemente 4a - 4e einer unter diesen mikrooptischen Elementen zumindest teilweise angeordneten Lichtsensoranordnung 4A - 4C gelenkt werden.

In Alternativen kann der Schritt des Strukturierens 1530 des Wafers beispielsweise auch vor dem Schritt des Erzeugens 1520 der Vielzahl von Lichtsensoranordnungen erfolgen.

Fig. 6A zeigt einen Querschnitt eines Beispiels 600, das dem aus Fig. 5A ähnlich ist, bei dem jedoch die mikrooptischen Elemente 1A''' - 1C''' nicht aus dem Bildsensor-Wafer 3 bzw. dem Halbleiterteil 3a selbst gebildet bzw. strukturiert sind, sondern additiv auf dem Bildsensor-Wafer 3 aufgebracht wurden. Diese additiven refraktiven Mikrooptik-Strukturen 1A''' - 1C''' können beispielsweise auf der Basis von Polymeren oder Glaspasten erzeugt werden. Derartige Beispiele 600 können daher auch kurz als Waferteilstücke bzw. mikrooptoelektronische Bauelemente mit einer additiv auf ein zu bondendes Substrat oder einen funktionalen Sensorwafer aufgebrachte Mikrooptik bezeichnet werden. Generell sind derartige additive Strukturen auch auf die anderen Beispiele anwendbar. Das additive Material kann diskret über den jeweiligen Lichtsensoranordnungen 4A - 4C aufgebracht werden oder als Schicht bzw. als Ganzes abgeschieden werden und anhand abtragender oder umformender Verfahren strukturiert werden. Die Linsen 1A''' - 1C''' können beispielsweise auch durch viskoses Fließen aus einzelnen Depots, die auf dem Bildsensor-Wafer aufgebracht werden, geformt werden.

Auch Stempeln und Prägen von Strukturen kann zur Herstellung der mikrooptischen Strukturen 1A''' - 1C''' verwendet werden. Die Mikrolinsen 1A''' - 1C''' oder auch andere mikrooptische Strukturen 1A''' - 1C''' können, in anderen Worten, durch Stempeltechniken, Grauton-Lithographie, Laserablation oder schichtweises Aufbauen hergestellt werden. Die meisten dieser Verfahren basieren dann jedoch auf der Verwendung von Kunststoffen. Bei weiteren Beispielen werden die Linsen 1A''' - 1C''' anhand der Oberflächenspannung viskoser Materialien aus einzelnen Depots von Kunststoff oder Glaspaste geschmolzen. In weiteren Beispielen werden selbstorganisierende Verfahren angewendet, bei denen sich beispielsweise Kugeln auf einer Oberfläche anordnen und die Basis für weitere Prozessschritte zur Formung der mikrooptischen Elemente 1A''' - 1C''' oder allgemein der Linsenmatrix bilden. Die Veispiele gemäß der Figuren 1A bis 5A weisen jedoch bessere optische Eigenschaften auf, und insbesondere die Veispiele gemäß den Figuren 1A bis 4A aufgrund des separaten optischen Wafers, und hier wiederum insbesondere bei der Verwendung von Glaswafern, da diese bessere optische Langzeiteigenschaften als Kunststoffe oder andere Materialen aufweisen.

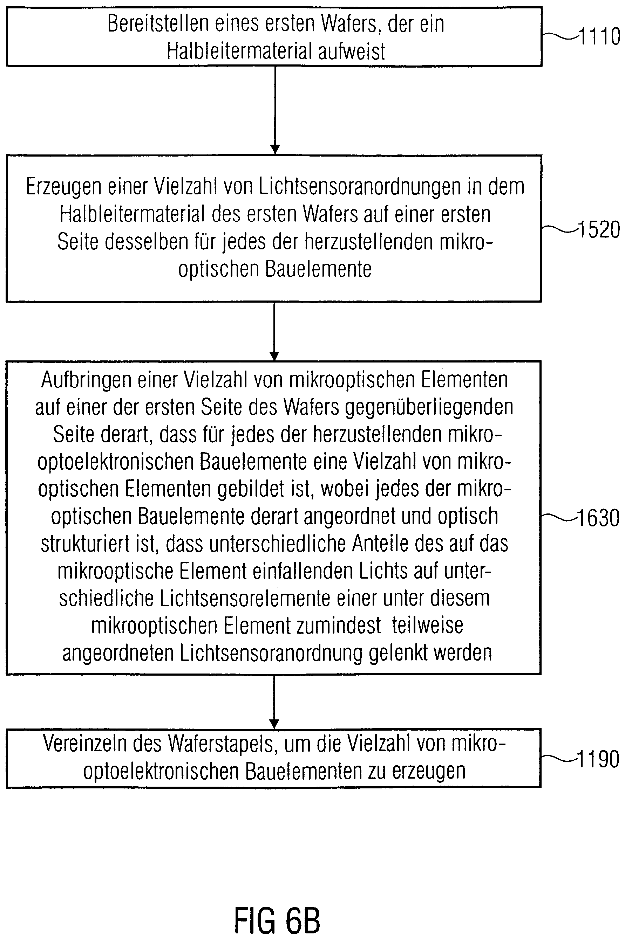

Fig. 6B zeigt ein Flussdiagramm eines Verfahrens zur Herstellung eines Wafers mit einer Vielzahl von mikrooptoelektronischen Bauelementen, dass dem aus Fig. 5B ähnlich ist. In dem Verfahren gemäß Fig. 6B wird jedoch, im Gegensatz zu dem Verfahren in Fig. 5B nicht der Glaswafer selbst optisch strukturiert, sondern durch Materialaufbringung ein zusätzliches, optisch transparentes Material auf den Glaswafer aufgebracht, und dieses zusätzliche Material optisch Strukturiert, um die mikrooptischen Elemente zu erzeugen. In anderen Worten, das Verfahren gemäß Fig. 6B weist anstelle des Schritts 1530 den folgenden Schritt 1630 auf: Aufbringen 1630 einer Vielzahl von mikrooptischen Elementen 1A''' - 1C''' auf einer der ersten Seite F des Wafers gegenüberliegenden Seite R derart, dass für jedes der herzustellenden mikrooptoelektronischen Bauelemente 600 eine Vielzahl von mikrooptischen Elementen gebildet ist, wobei jedes der mikrooptischen Bauelemente 1A''' - 1C''' derart angeordnet und optisch strukturiert ist, dass unterschiedliche Anteile des auf das mikrooptische Element einfallenden Lichts auf unterschiedliche Lichtsensorelemente 4a - 4e einer unter diesem mikrooptischen Element zumindest teilweise angeordneten Lichtsensoranordnung 4A - 4C gelenkt werden.

Weitere Beispiele können sowohl eine optische Strukturierung des Glaswafers selbst (s. Fig. 1A und 1D; 2A; 3A und 3B; 4A und 4B; 5A und 5B) als auch eine Strukturierung eines zusätzlich auf den Glaswafer aufgebrachten zusätzlichen Materials, z.B. Resist, etc. (s. Fig. 6A und 6B), aufweisen.

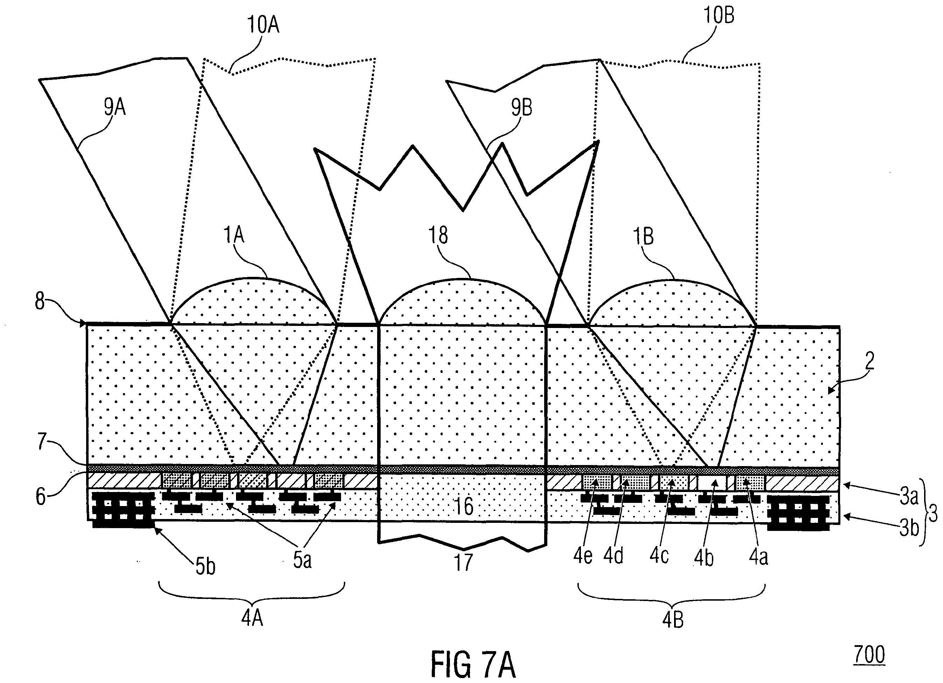

Fig. 7A zeigt als Ausführungsbeispiel 700 einen Querschnitt eine Abwandlung gemäß Fig. 1A, die sich dadurch von dem Ausführungsbeispiel 100 gemäß Fig. 1A unterscheidet, dass der Bildsensor-Wafer 3 ein oder mehrere optisch transparente Fenster 16 aufweist, durch die das Licht 17 einer hinter dem Sensorwafer 3 liegenden Lichtquelle hindurchtreten kann. In anderen Worten, der Lichtstrahl 17 tritt durch das Fenster 16 in den Bildsensor-Wafer 3 und durch den Mikrooptik-Wafer 2 und kann ferner durch ein optionales mikrooptisches Element 18, beispielsweise in Linsenform, wie in Fig. 7A dargestellt, gebrochen werden. Je nach Anwendungsfall können analog zu den mikrooptischen Strukturen 1A und 1B beliebige refraktive oder diffraktive oder andere Optiken zum Einsatz kommen. Fig. 7A zeigt damit in anderen Worten eine Mikrooptik-Sensorwafer-Kombination 700 mit einem lichtdurchlässigen Fenster in dem Sensorwafer 3.

Ausführungsbeispiele gemäß Fig. 7A bilden eine neue Möglichkeit, unabhängig von der Art des Bondverfahrens, ein Fenster oder eine Ansammlung von Fenstern im Sensorwafer 3 für die Integration von Lichtquellen im optischen Strahlengang des Mikrooptik-Wafers zu ermöglichen. Derartige Integrationen von Lichtquellen können zu verschiedenen Zwecken verwendet werden, z. B. kann über die Beleuchtung von Objekten hinaus eine modulierte Lichtquelle zur Messung von Objektabständen dienen, beispielsweise durch Laufzeitunterschiede des Lichts. Eine lokale Projektion der Lichtquelle kann als Referenzpunkt z. B. für Multikamera-Anwendungen dienen. Die Aussendung von Lichtsignalen von verschiedenen Stellen des Sensorwafers aus kann selektiv Objekte im Sichtfeld beleuchten. Auch kann der Sensorwafer vordringlich so gebaut sein, dass mehr Lichtauslässe als Sensorelemente in ihm existieren und er eher zur Kontrolle der Beleuchtungswirkung im beleuchteten Szenario dient. Weitere Ausführungsbeispiele umfassen auch aktive Wafer mit darauf verteilten Lichtemittern und Lichtsensoren an der Stelle des Sensorwafers.

Dieses Fensterkonzept ist entsprechend auch auf alle anderen Beispiele anwendbar. Vergleichsbeispiele der mikrooptoelektronischen Bauelemente weisen mikrooptische Strukturen auf, deren Durchmesser, z.B. bei sphärischen oder kreisförmigen Strukturen, oder deren Breite, z.B. bei zylindrischen oder länglichen Strukturen, kleiner als $500\mu m$ und größer als $5\mu m$ sind, vorzugsweise kleiner als $250\mu m$ und größer als $10\mu m$ sind.

Alternative Vergleichsbeispielen schaffen ein Verfahren zur Herstellung eines Wafers oder eines Waferstapels mit einer Vielzahl von mikrooptoelektronischen Bauelementen in Form von Waferteilstücken oder Waferstapelteilstücken, wobei sich die zuvor beschriebenen Verfahren lediglich von dem letzgenannten im Wesentlichen nur durch den zusätzlichen Schritt des Vereinzelns des Wafers oder Waferstapels unterscheiden, um die diskreten mikrooptischen Bauelemente zu erzeugen.

Aus der Verwendung von Wafertechnologien ergibt sich der Vorteil einer hohen Montagepräzision sowohl in lateraler als auch in vertikaler Richtung, d.h. senkrecht zur Waferoberfläche. Eine hohe Oberflächengüte wird durch ausgereifte Schleif- und Polierverfahren erreicht und es sind viele Methoden zur Beschichtung und Strukturierung möglich, die dem Bauteil zusätzliche Qualitäten verleihen können. Sie können zudem eingesetzt werden, um weitere Elemente elektrisch oder auch nur zu mechanischen Zwecken anzuschließen, z. B. durch Löten. Damit bilden die aufgeführten Vergleichsbeispiele eine Basis für vielfältige weiterführende Aufbauten, die den bestehenden Trends zur Optikin-Die Montage von optisch unstrukturierten Glaswafern im optischen Licht-Eintrittsbereich von Bildsensoren ist eine weitere Möglichkeit der hybriden Integration, beispielsweise mittels Adhäsionsbonding, z.B. um eine Handhabung ultradünner Bildsensoren zu ermöglichen. Derartige Bauteile werden jedoch von der Schaltungsseite her kontaktiert, so dass ein frontseitig angebrachter Wafer nach dem Dünnen wieder entfernt wird. Da der Wafer hier keine abbildende Funktion hat, ist bei dieser Form der Anwendung auch keine besondere Positioniergenauigkeit von Nöten.

Die Lichtfeld-Fotografie oder "integrale Fotografie" ist schon seit längerer Zeit bekannt und wird seit den 90er Jahren von Fachleuten aus dem Bereich der digitalen Bildverarbeitung, insbesondere an der Stanford University, USA, mit zunehmendem Interesse verfolgt. Die Qualität der Lichtfeld-Aufnahmen hängt stark von der Sensorauflösung ab, so dass sich die heutigen Grenzen durch die Rückseitenbelichtung stark erweitern lassen. Hierfür werden weiterhin genaue Justierverfahren für die Optikintegration entscheidend sein, da mikrometergenaue Positionierungen mit feinmechanischen Mitteln nur schwer zu erreichen sind. Vor dem Hintergrund der oben dargestellten heutigen Situation nehmen die zuvor beschriebenen Verfahren zur waferbasierten Mikrooptik-Integration grundlegende Schlüsselpositionen ein, um neue Anwendungen von Mikrooptiken mit einem mittelbis langfristigen Markthorizont als kostengünstige und dennoch optisch hochwertige Produkte zu ermöglichen.

Im Folgenden wird eine beispielhafte Berechnung eines Linsenwafers für einen Lichtfeld-Sensor als mikrooptisches Bauteil beschrieben. Dabei wird zunächst auf die Berechnung des Krümmungsradius nach der Linsengleichung eingegangen. Hier wird von einer sphärischen Linsengeometrie ausgegangen, die als Linsenkalotte 1A auf der Oberseite des Glaswafers 2, wie beispielsweise in Fig. 1A gezeigt, angeordnet ist. Der sensorseitige Fokus der Linse 1A befindet sich in diesem Berechnungsbeispiel auf der Rückseite R' des Glaswafers, also unmittelbar an der Grenzfläche zum Bildsensor bzw. des Halbleitermaterials 3a. Dadurch werden einfallende Parallelstrahlen idealerweise als Punkte auf dem Bildsensor 4A mit seinen Lichtsensorelementen 4a-4e abgebildet.

In den folgenden Berechnungen, die anhand des Beispiels der Fig. 1A erläutert werden, wird eine Linse 1A aus Borsilikatglas mit Luft (Brechungsindex $n_{Luft}$ = 1) als darüber liegendem Medium angenommen. Beispiele für Silikatgläser zum Waferbonden mit Silizium, die beispielsweise eine Dicke von typischerweise 100 μm bis 1,1 mm aufweisen können, sind: Borofloat®-Glas (Markenname von Schott) $n_d$ = 1,47140 bei 587,6nm; Pyrex® (Markenname von Corning Inc.) $n_d$ = 1,474 bei 588nm; und Schott "AF32" Alumino-Borosilikatglas (AF steht für alkalifrei). Dabei wird für den Brechungsindex $n_d$ des Glaswafers 2 im Folgenden auch der Parameter n ohne Index verwendet.

Ferner wird für die Berechnungen angenommen, dass der Brennpunkt des Systems sich innerhalb des Glaswafers 2 befindet und es werden keine linsentypischen Abbildungsfehler betrachtet.

Die Brennweite f berechnet sich als Abstand vom Scheitelpunkt der Linsenkalotte 1A nach

$$f = \frac{n \cdot R}{n-1}$$

(s. Bergmann-Schäfer "Lehrbuch der Experimentalphysik") mit f als Brennweite der Linse, n als Brechungsindex des Glaswafer-Materials (n = 1,47) und R als Krümmungsradius der Linsenoberfläche. Nach dem Krümmungsradius aufgelöst erhält man:

$$R = \frac{f \cdot (n-1)}{n} \qquad \text{[Formel 1].}$$

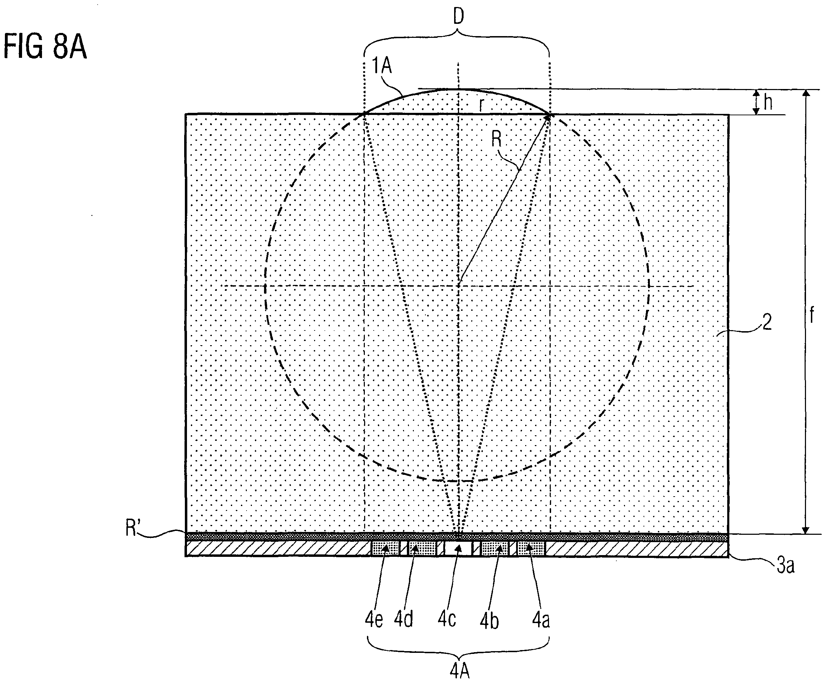

Fig. 8A zeigt die Parameter an dem Beispiel der Lichtsensoranordnung 4A mit den Lichtsensorelementen 4a-4e gemäß Fig. 1A. Wie in Fig. 8A ersichtlich, bildet die Kalotte 1A das mikrooptische Element, das über der Lichtsensoranordnung 4A angeordnet ist.

Im Folgenden wird die Berechnung des Linsendurchmessers D als Eintrittspupille näher erläutert. Nach Ren NG, Marc Levoy, Mathieu Bredif, Gene Duval, Mark Horowitz, Pat Harahan: "Light-Field Photography with a Hand-Held Plenoptic Camera", Stanford Tech Report CTSR 2005-02, findet eine optimale Nutzung der Bildsensorfläche für die Lichtfeld-Photographie ohne Überlappung der Teilbilder statt, wenn die Eintrittspupille jeder Mikrolinse 1A mit der Kameraoptik abgestimmt ist. In der Photographie ist es üblich, die Öffnung des Lichteintritts eines Kameraobjektivs mit einer Blende zu regulieren. Der Zusammenhang zwischen Blendenzahl BZ, Durchmesser D der Eintrittspupille 1A und der Brennweite f ist folgender:

$$D = \frac{f}{BZ}$$

bzw. mit dem Radius r der Linsenkalotte

$$r = \frac{f}{2 \cdot BZ} \qquad [\text{Formel 2}].$$

Im Folgenden wird auf die geometrische Beziehung zwischen Linsenkalotte und Waferdicke eingegangen. Mit dem zuvor bestimmten Krümmungsradius R und dem Linsenradius r lässt sich nach dem Satz des Pythagoras die Höhe der Linsenkalotte bestimmen:

$$R^2 = r^2 + (R-h)^2$$

bzw.

$$h = R - \sqrt{R^2 - r^2} \qquad [\text{Formel 3}].$$

Durch Einfügen der oben entwickelten Formeln ergibt sich die folgende Gleichung:

$$h = \frac{f(n-1)}{n} - \sqrt{\left(\frac{f(n-1)}{n}\right)^2 - \left(\frac{f}{2 \cdot BZ}\right)^2} \; .$$

Vereinfacht man diesen Ausdruck, so wird ersichtlich, dass bei gleichen optischen Randbedingungen die Linsenhöhe h zur Waferdicke bei einer rein geometrischen Betrachtung proportional skaliert werden kann:

$$\frac{h}{f} = \frac{(n-1)}{n} - \sqrt{\left(\frac{n-1}{n}\right)^2 - \left(\frac{1}{2 \cdot BZ}\right)^2} \qquad [\text{Formel 4}].$$

Als Beispiel wird ein System nach Fig. 1A mit Borsilikat-Wafer 2 und einer Brennzahl BZ=4 betrachtet. Die Brennweite f entspricht dabei der Waferdicke inklusive der Linsenkalotte 1A. Dazu werden zunächst die Geometriegrößen r und h allgemein entwickelt, d.h. relativ zur Waferdicke. Aus Formel 2 erhält man den relativen Linsenradius:

$$\frac{r}{f} = \frac{1}{2 \cdot BZ} = \frac{1}{2 \cdot 4} = 12{,}5\% \; .$$

Aus Formel 4 erhält man die relative Linsenhöhe:

$$\frac{h}{f} = \frac{n-1}{n} - \sqrt{\left(\frac{n-1}{n}\right)^2 - \left(\frac{1}{2 \cdot BZ}\right)^2} = \frac{1{,}47-1}{1{,}47} - \sqrt{\left(\frac{1{,}47-1}{1{,}47}\right)^2 - \left(\frac{1}{2 \cdot 4}\right)^2} = 2{,}54\% \; .$$

Nach Formel 1 kann der relative Krümmungsradius R/f wie folgt bestimmt werden:

$$\frac{R}{f} = \frac{n-1}{n} = 31{,}97\%.$$

Bei einem Wafer von 600 $\mu$m Dicke ist damit die Geometrie folgendermaßen: Linsenhöhe h = 15,27 $\mu$m, Linsenradius r = 75 $\mu$m und Krümmungsradius R = 192 $\mu$m. Diese Konfiguration erlaubt es beispielsweise, bei einer angenommenen Breite eines einzelnen Lichtsensorelements 4a-4e von 5 $\mu$m eine 75 $\mu$m und Krümmungsradius R = 192 $\mu$m. Diese Konfiguration erlaubt es beispielsweise, bei einer angenommenen Breite eines einzelnen Lichtsensorelements 4a-4e von 5 $\mu$m eine Anzahl von maximal 15 Lichtsensorelementen unter der Mikrolinse 1A in einer Reihe anzuordnen.

Sind die Lichtsensorelemente hingegen nur 1 $\mu$m groß, so können unter der Mikrolinse 1A bis zu 75 Sensorzellen pro Reihe angeordnet werden. Dadurch wird die Qualität der Tiefenauflösung der Lichtfeld-Aufnahme signifikant verbessert, wobei eine Verbesserung der optischen Abbildungsleistung, z.B. durch die eine asphärische Linsenform erforderlich werden kann.

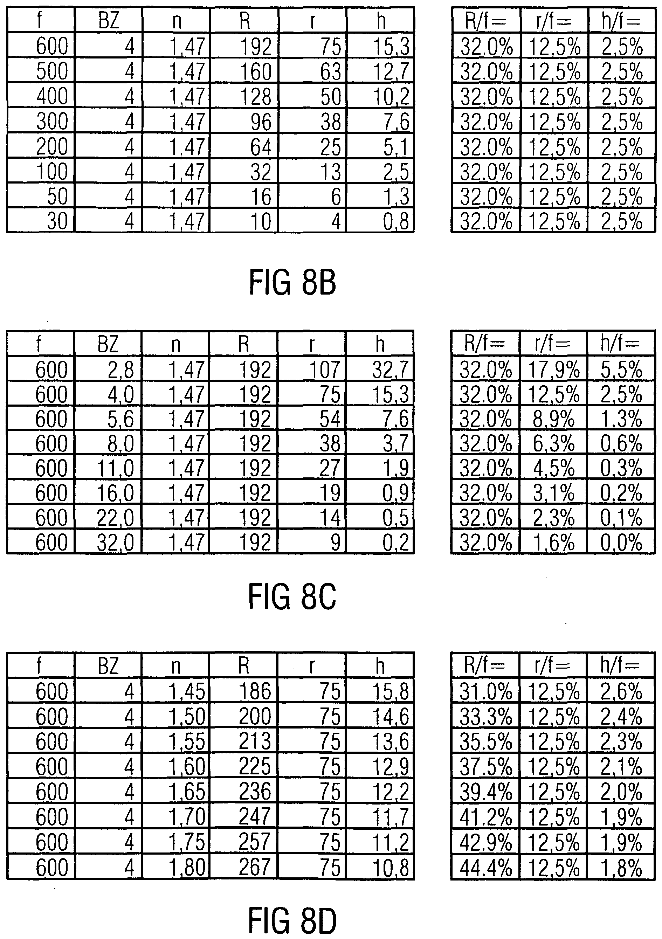

Die Tabellen 8B-8D zeigen weitere Zahlenbeispiele, die nach dem oben gezeigten Schema berechnet wurden. Die Längenangaben sind in $\mu$m angegeben. Dabei zeigt Fig. 8B eine Tabelle, bei der die Brennweite der Linse 1A variiert wurde, nämlich von 30 $\mu$m bis 600 $\mu$m. In der Fig. 8C wird eine Tabelle gezeigt, bei der die Blendenzahl BZ variiert wurde, nämlich zwischen dem Wert 2,8 und 32. Fig. 8D zeigt eine Tabelle, bei der die Glaswafer-Materialien und damit der Brechungsindex n variiert wurden, nämlich von 1,45 bis 1,80.

Im Folgenden wird auf die Dimensionierung der Beispiele und Ausführungsbeispiele gemäß der Fig. 1A bis 7A eingegangen.

Bei Beispielen gemäß Fig. 1A erfüllt der Glaswafer 2 beispielsweise eine stabilitätserhöhende Funktion, da der Sensorwafer 3 sehr dünn ist. Die Dicke des Glaswafers ist damit beispielsweise im Bereich von 100 bis 1.000 $\mu$m, vorzugsweise zwischen 200 $\mu$m und 600 $\mu$m, ganz besonders bevorzugt zwischen 300 $\mu$m und 400 $\mu$m. Die Linsenradien sind damit bevorzugt zwischen 13 $\mu$m und 107 $\mu$m, besonders bevorzugt zwischen 19 $\mu$m und 71 $\mu$m. Unter jeder Linse 1A bis 1C befindet sich eine entsprechende Anzahl von Lichtsensorelementen mit Abmessungen in zumindest einer Richtung von 0,5 $\mu$m bis 10 $\mu$m, bevorzugt von 0,8 $\mu$m bis 5 $\mu$m, besonders bevorzugt von 0,8 $\mu$m bis 2 $\mu$m. In der besonders bevorzugten Version ergeben sich dadurch in einer Reihe pro Anordnung zwischen 9 und 88 Lichtsensorelemente.

Bei Beispielen gemäß Fig. 2A braucht der Glaswafer 2 keine stabilisierende Wirkung auszüüben, da der Sensorwafer 3 dick genug ist. Er ist dadurch nur durch seine eigene Handhabbarkeit beschränkt. Derartige Beispiele können beispielsweise eine Dicke von 30 $\mu$m bis 1.000 $\mu$m aufweisen, bevorzugt aber zwischen 50 $\mu$m und 500 $\mu$m, besonders bevorzugt zwischen 100 $\mu$m und 300 $\mu$m. Dabei ergeben sich im letzteren Falle Linsenradien zwischen 6 $\mu$m und 54 $\mu$m.

Bei Beispielen gemäß Fig. 3A sind die beispielhaft angegebenen Berechnungen nicht direkt anwendbar, da die optische Anordnung anders, d.h. konkav ist. Aus technologischer Sicht ist jedoch die Dicke des gesamten Waferstapels sinnvollerweise zwischen 200 $\mu$m und 1000 $\mu$m, wobei der Zwischenwafer 13 vorzugsweise dicker als der Glaswafer 2 gewählt wird. Die Glaswafer 2 hat beispielsweise bevorzugt mindestens eine Dicke von 50 $\mu$m, die auch durch ein nachträgliches Schleifen und Polieren des Waferstapels erzielt werden kann.

Für Veispiele gemäß Fig. 4A gelten sinngemäß die Angaben für Beispiele gemäß Fig. 3A.

Bei Beispielen gemäß Fig. 5A ist zu beachten, dass das Brechungsverhalten von Infrarot-Licht sich von sichtbarem Licht unterscheidet. Silizium hat zudem einen hohen Brechungsindex, z.B. 3,4 bei 10 $\mu$m Wellenlänge. Je nach spektraler Auslegung der Lichtsensorzellen ist dies bei der Berechnung derartiger Beispiele zu berücksichtigen. Als Anhaltswerte für die Linsenradien können jedoch die oben genannten Daten aus Fig. 1A herangezogen werden, da Silizium bereits bei 1,2 $\mu$m Wellenlänge als transparent gilt. Hierbei sind funktionsgemäß die Werte des Glaswafers auf den Siliziumwafer, zu übertragen.

Für Beispiele eispiele gemäß Fig. 6A gelten sinngemäß die Erläuterungen zu den Beispielen gemäß Fig. 5A, und für Ausführungsbeispiele gemäß Fig. 7A die Erläuterungen für Beispiele eispiele gemäß Fig. 1A.

Im Bereich der Anwendungen ist die Lichtfeld-Fotografie nur eines der möglichen Beispiele für innovative Produkte und Techniken. Es ist z. B. auch denkbar, "farbechte" Kameras oder Zeilenscanner zu bauen, die anstelle von organischen Filterschichten auf die wellenlängenabhängige Lichtbrechung durch Prismen oder Beugungsgitter zurückgreifen. Das Spektrum wird dann auf mehrere Lichtsensoren ohne Farbfilter verteilt, so dass jede Lichtsensorandordnung quasi ein Spektrometer darstellt.

Wie dargelegt bieten Ausführungsbeispiele Vorteile in Zusammenhang mit den beschriebenen Bestreben zur Herstellung von Sub-Mikrometer Pixeln und der Rückseitenbeleuchtung. Die Alternative der Einzelchip-Positionierung ist möglich, allerdings sind die Positionstoleranzen dann starker Streuung unterworfen.

Im Consumerbereich ist die Abbildungsleistung erschwinglicher Objektive mit heutigen Auflösungen ausgereizt. Ausführungsbeispiele der vorliegenden Erfindung ermöglichen jedoch durch hochauflösende kleine Sensorchips, auch billigere und kleinere Kameras mit hoher Leistung. Derartige miniaturisierte und/oder preiswerte Kamerasysteme können auch industriell angewendet werden, im Automobilbereich oder der Sicherheitstechnik, wo sie zur maschinellen Bildverarbeitung eingesetzt werden können.

Wie es aus obiger Beschreibung hervorging, kann der Schritt des Strukturierens 1140 des zweiten Wafers mittels Ätzens erfolgen. Der Schritt des Strukturierens 1140 des zweiten Wafers mittels Umformen kann durch viskose Formgebung erfolgen und zwar vor dem Schritt des Erzeugens 1150 des Waferstapels mittels Waferbonding. Das optisch transparente Material kann ein Glas sein, das hinsichtlich des thermischen Ausdehnungskoeffizienten an das Halbleitermaterial des ersten Wafers angepasst ist.

## Patentansprüche

1. Verfahren zur Herstellung einer Vielzahl von mikrooptoelektronischen Bauelementen (100 - 400; 700) für die Lichtfeld-Fotografie, mit den folgenden Schritten:

   Bereitstellen (1110) eines ersten Wafers (3), der ein Halbleitermaterial (3a) aufweist;
   Bereitstellen (1120) eines zweiten Wafers (2), der ein optisch transparentes Material aufweist;
   Erzeugen (1130) einer Vielzahl von Lichtsensoranordnungen (4A - 4C) in dem Halbleitermaterial (3a) des ersten Wafers (3) für jedes der herzustellenden mikrooptischen Bauelemente (100 - 400; 700);
   Strukturieren (1140) des zweiten Wafers (2) derart, dass darin für jedes der herzustellenden mikrooptoelektronischen Bauelemente (100 - 400; 700) eine Vielzahl von mikrooptischen Linsen (1A - 1C; 1A' - 1C') gebildet ist;
   Erzeugen (1150) eines Waferstapels mittels Waferbonding, der den ersten Wafer (3, 3', 3") und den darüber angeordneten zweiten Wafer (2) aufweist, wobei jedes der mikrooptischen Linsen (1A - 1C; 1A' - 1C') derart angeordnet und optisch strukturiert ist, dass von einem Punkt (32) eines Objekts durch eine Hauptlinse (31) auf die mikrooptische Linse gelenkte Lichtstrahlen mit unterschiedlichen Einfallswinkeln (9A - 9C, 10A - 10C; 15a - 15c) auf unterschiedliche Lichtsensorelemente (4a - 4e) einer unter dieser mikrooptischen Linse zumindest teilweise angeordneten Lichtsensoranordnung (4A - 4C) gelenkt werden; und
   Vereinzeln (1190) des Waferstapels in die Vielzahl von mikrooptoelektronischen Bauelementen (100 - 400; 700), **dadurch gekennzeichnet, dass** das Verfahren den zusätzlichen Schritt aufweist:

   Erzeugen eines optisch transparenten Fensters (16) in dem ersten Wafer (3), so dass Licht einer jenseits einer dem zweiten Wafer abgewandten Seite des ersten Wafers (3) liegenden Lichtquelle durch den ersten Wafer hindurchtreten kann.

2. Verfahren nach Anspruch 1, wobei das Waferbonding ein anodisches Waferbonding oder Silizium-Direktbonding ist und der Schritt des Erzeugens (1130) der Vielzahl von Lichtsensoranordnungen nach dem Schritt des Erzeugens (1150) des Waferstapels erfolgt.

3. Verfahren nach Anspruch 1, wobei das Waferbonding ein Waferbonding mittels vollflächigen Klebens ist und der Schritt des Erzeugens (1130) der Vielzahl von Lichtsensoranordnungen vor dem Schritt des Erzeugens (1150) des Waferstapels erfolgt.

4. Verfahren nach einem der Ansprüche 1 bis 3, mit dem zusätzlichen Schritt:

   Erzeugen (4110) einer Vielzahl von Kavitäten (13A - 13C) in dem ersten Wafer, wobei die Kavitäten (13A - 13C) des ersten Wafers (13) derart angeordnet sind, dass die unterschiedlichen Anteile (15a - 15c) des auf die mikrooptische Linse (1A' - 1C') einfallenden Lichts auf die unterschiedlichen Lichtsensorelemente (4a - 4e) der unter dieser mikrooptischen Linse zumindest teilweise angeordneten Lichtsensoranordnung (4A - 4C) gelenkt werden können.

5. Verfahren nach einem der Ansprüche 1 bis 4, mit den zusätzlichen Schritten:

   Bereitstellen (3110) eines zusätzlichen Wafers;
   Erzeugen (3120) einer Vielzahl von Kavitäten (13A - 13C) in dem zusätzlichen Wafer; und
   Erzeugen (1150') eines Waferstapels mittels Waferbonding, der zwischen dem ersten Wafer (3) und dem zweiten Wafer (2) den zusätzlichen Wafer (13) aufweist, wobei die Kavitäten (13A - 13C) des zusätzlichen Wafers (13) derart angeordnet sind, dass die unterschiedlichen Anteile (15a - 15c) des auf die mikrooptische Linse (1A' - 1C') einfallenden Lichts auf die unterschiedlichen Lichtsensorelemente (4a - 4e) der unter dieser mikrooptischen Linse zumindest teilweise angeordneten Lichtsensoranordnung (4A - 4C) gelenkt werden können.

6. Mikrooptoelektronisches Bauelement (100 - 400; 700) für die Lichtfeld-Fotografie, das einen Stapel aus einem ersten Waferteilstück (3) und einem darüber angeordneten zweiten Waferteilstück (2) aufweist, wobei das erste Waferteilstück (3) ein Halbleitermaterial (3a) aufweist, in dem eine Vielzahl von Lichtsensoranordnungen (4A - 4C) gebildet ist, und jede der Vielzahl von Lichtsensoranordnungen eine Vielzahl von Lichtsensorelementen (4a - 4e) aufweist, und wobei das zweite Waferteilstück (2) ein optisch transparentes Material aufweist und derart strukturiert ist, dass darin eine Vielzahl von mikrooptischen Linsen (1A - 1C, 1A' - 1C') gebildet ist, wobei jedes der Vielzahl von mikrooptischen Linsen wiederum derart optisch strukturiert ist, dass von einem Punkt (32) eines Objekts durch eine Hauptlinse (31) auf die mikrooptische Linse gelenkte Lichtstrahlen mit unterschiedlichen Einfallswinkeln (9A - 9C, 10A - 10C; 15a - 15c) auf unterschiedliche Lichtsensorelemente einer unter dieser mikrooptischen Linse zumindest teilweise angeordneten Lichtsensoranordnung (4A - 4C) gelenkt werden, **dadurch gekennzeichnet, dass** das mikrooptoelektronische Bauelement (700) ein optisch transparentes Fenster (16) in dem ersten Waferteilstück (3) aufweist, durch das Licht einer jenseits einer dem zweiten Wafer abgewandten Seite des ersten Waferteilstücks (3) liegenden Lichtquelle durch das erste Waferteilstück hindurchtreten kann.

7. Mikrooptoelektronisches Bauelement nach Anspruch 6, bei dem das erste Waferteilstück (3) für eine Rückseitenbelichtung ausgebildet ist und das zweite Waferteilstück (2) auf einer Rückseite (R) des ersten Waferteilstücks (3) angeordnet ist.

8. Mikrooptoelektronisches Bauelement (300; 700) nach einem der Ansprüche 6 und 7, bei dem zwischen dem ersten Waferteilstück (3; 3') und dem zweiten Waferteilstück (2) ein zusätzliches Waferteilstück (13) angeordnet ist, wobei das zusätzliche Waferteilstück (13) Kavitäten (13A - 13C) aufweist, die derart über den Lichtsensoranordnungen (4A - 4C) angeordnet sind, dass das einfallende Licht auf die unterschiedlichen Lichtsensorelemente (4a - 4e) fallen kann.

9. Mikrooptoelektronisches Bauelement (400; 700) nach einem der Ansprüche 6 bis 8, wobei das erste Waferteilstück (3') Kavitäten (13A - 13C) aufweist, die derart über den Lichtsensoranordnungen (4A - 4C) angeordnet sind, dass das einfallende Licht auf die unterschiedlichen Lichtsensorelemente (4a - 4e) fallen kann.

## Claims

1. Method of manufacturing a multitude of micro-optoelectronic devices (100 - 400; 700) for light-field photography, comprising:

    providing (1110) a first wafer (3) comprising a semiconductor material (3a);
    providing (1120) a second wafer (2) comprising an optically transparent material;
    producing (1130) a multitude of light sensor arrangements (4A - 4C) in the semiconductor material (3a) of the first wafer (3) for each of the micro-optical devices (100 - 400; 700) to be manufactured;
    structuring (1140) the second wafer (2) such that a multitude of micro-optical lenses (1A - 1C; 1A' - 1C') are formed therein for each of the micro-optoelectronic devices (100 - 400; 700) to be manufactured;
    producing (1150) a wafer stack by means of wafer bonding, said wafer stack comprising the first wafer (3, 3', 3") and the second wafer (2) arranged above same, each of the micro-optical lenses (1A - 1C; 1A' - 1C') being arranged and optically structured such that light beams directed from a point (32) of an object onto the micro-optical lens by a main lens (31) at different angles of incidence (9A - 9C, 10A - 10C; 15a - 15c) are directed onto different light sensor elements (4a - 4e) of a light sensor arrangement (4A - 4C) at least partly arranged below said micro-optical lens; and
    dicing (1190) the wafer stack into the multitude of micro-optoelectronic devices (100 - 400; 700),
    **characterized in that** the method additionally comprises:

    producing an optically transparent window (16) in the first wafer (3) so that light of a light source located beyond a side of the first wafer (3) which faces away from the second wafer may pass through the first wafer.

2. Method as claimed in claim 1, wherein wafer bonding is anodic wafer bonding or silicon direct bonding, and the step of producing (1130) the multitude of light sensor arrangements is effected following the step of producing (1150) the wafer stack.

3. Method as claimed in claim 1, wherein wafer bonding is wafer bonding by means of all-over adhesion, and the step of producing (1130) the multitude of light sensor arrangements is effected prior to the step of producing (1150) the wafer stack.

4. Method as claimed in any of claims 1 to 3, additionally comprising:

producing (4110) a multitude of cavities (13A - 13C) in the first wafer, said cavities (13A - 13C) of the first wafer (13) being disposed such that the different portions (15a - 15c) of the light incident on the micro-optical lens (1A' - 1C') may be directed onto the different light sensor elements (4a - 4e) of the light sensor arrangement (4A - 4C) at least partly arranged below said micro-optical lens.

5. Method as claimed in claims 1 or 4, additionally comprising:

providing (3110) an additional wafer;
producing (3120) a multitude of cavities (13A - 13C) in the additional wafer; and
producing (1150') a wafer stack by means of wafer bonding, said wafer stack comprising the additional wafer (13) between the first wafer (3) and the second wafer (2), said cavities (13A - 13C) of the additional wafer (13) being disposed such that the different portions (15a - 15c) of the light incident on the micro-optical lens (1A' - 1C') may be directed onto the different light sensor elements (4a - 4e) of the light sensor arrangement (4A - 4C) at least partly arranged below said micro-optical lens.

6. Micro-optoelectronic device (100 - 400; 700) for light-field photography, comprising a stack consisting of a first wafer section (3) and a second wafer section (2) arranged above same,
the first wafer section (3) comprising a semiconductor material (3a) which has a multitude of light sensor arrangements (4A - 4C) formed therein, and each of the multitude of light sensor arrangements comprising a multitude of light sensor elements (4a - 4e), and
the second wafer section (2) comprising an optically transparent material and being structured such that a multitude of micro-optical lenses (1A - 1C, 1A' - 1C') are formed therein, each of the multitude of micro-optical lenses, again, being optically structured such that light beams directed from a point (32) of an object onto the micro-optical lens by a main lens (31) at different angles of incidence (9A - 9C, 10A - 10C; 15a - 15c) are directed onto different light sensor elements of a light sensor arrangement (4A - 4C) at least partly arranged below said micro-optical lens
**characterized in that**
the micro-optoelectronic device (700) comprising an optically transparent window (16) in the first wafer section (3) through which light of a light source located beyond a side of the first wafer (3) which faces away from the second wafer may pass through the first wafer section.

7. Micro-optoelectronic device as claimed in claim 6, wherein the first wafer section (3) is configured for rear-side illumination, and the second wafer section (2) is arranged on a rear side (R) of the first wafer section (3).

8. Micro-optoelectronic device (300; 700) as claimed in any one of claims 6 and 7, wherein an additional wafer section (13) is arranged between the first wafer section (3; 3') and the second wafer section (2), said additional wafer section (13) comprising cavities (13A - 13C) disposed above the light sensor arrangements (4A - 4C) such that the incident light may fall on the different light sensor elements (4a - 4e).

9. Micro-optoelectronic device (400; 700) as claimed in any one of claims 6 to 8, the first wafer section (3') comprising cavities (13A - 13C) disposed above the light sensor arrangements (4A - 4C) such that the incident light may fall can the different light sensor elements (4a - 4e).

## Revendications

1. Procédé de fabrication d'une pluralité de composants micro-optoélectroniques (100 à 400; 700) pour la photographie de champ de lumière, aux étapes suivantes consistant à:

préparer (1110) une première plaquette (3) qui présente un matériau semi-conducteur (3a);
préparer (1120) une deuxième plaquette (2) qui présente un matériau optiquement transparent;
générer (1130) une pluralité d'aménagements de capteurs de lumière (4A à 4C) dans le matériau semi-conducteur (3a) de la première plaquette (3) pour chacun des composants micro-optiques à fabriquer (100 à 400; 700);

structurer (1140) la deuxième plaquette (2) de sorte que dans cette dernière soient formées, pour chacun des composants micro-optoélectronique à fabriquer (100 à 400; 700), une pluralité de lentilles micro-optiques (1A à 1C; 1A' à 1C');

générer (1150) une pile de plaquettes au moyen d'un assemblage de plaquettes qui présente la première plaquette (3, 3' 3") et la deuxième plaquette (2) disposée au-dessus de cette dernière, où chacune des lentilles micro-optiques (1A à 1C; 1A' à 1C') est disposée et structurée optiquement de sorte que, à partir d'un point (32) d'un objet, des faisceaux de lumière dirigés par une lentille principale (31) sur la lentille micro-optique soient dirigés selon des angles d'incidence (9A à 9C, 10A à 10C; 15a à 15c) différents sur des éléments de détection de lumière (4a à 4e) d'un aménagement de capteurs de lumière (4A à 4C) disposé au moins partiellement au-dessous de cette lentille micro-optique; et

séparer (1190) la pile de plaquettes en la pluralité de composants micro-optoélectroniques (100 à 400; 700), **caractérisé par le fait que**

le procédé présente l'étape additionnelle consistant à:

générer une fenêtre optiquement transparente (16) dans la première plaquette (3) de sorte que la lumière d'une source de lumière située au-delà d'un côté de la première plaque (3), opposé à la deuxième plaquette, puisse passer à travers la première plaquette.

2. Procédé selon la revendication 1, dans lequel l'assemblage de plaquettes est un assemblage de plaquettes anodique ou un assemblage direct par silicium et l'étape consistant à générer (1130) la pluralité d'aménagements de capteurs de lumière a lieu après l'étape consistant à générer (1150) la pile de plaquettes.

3. Procédé selon la revendication 1, dans lequel l'assemblage de plaquettes est un assemblage de plaquettes par collage sur toute la surface et l'étape consistant à générer (1130) la pluralité d'aménagements de capteurs de lumière a lieu avant l'étape consistant à générer (1150) la pile de plaquettes.

4. Procédé selon l'une des revendications 1 à 3, avec l'étape additionnelle consistant à:

générer (4110) une pluralité de cavités (13A à 13C) dans la première plaquette, où les cavités (13A à 13C) de la première plaquette (13) sont disposées de sorte que les différentes parts (15a à 15c) de la lumière incidente sur la lentille micro-optique (1A' à 1C') puissent être dirigées vers les différents éléments de détection de lumière (4a à 4e) de l'aménagement de capteurs de lumière (4A à 4C) disposé au moins partiellement au-dessous de cette lentille micro-optique.

5. Procédé selon l'une des revendications 1 à 4, aux étapes additionnelles consistant à:

préparer (3110) une plaquette additionnelle;
générer (3120) une pluralité de cavités (13A à 13C) dans la plaquette additionnelle; et
générer (1150') une pile de plaquettes au moyen d'un assemblage de plaquettes qui présente, entre la première plaquette (3) et la deuxième plaquette (2), la plaquette additionnelle (13), où les cavités (13A à 13C) de la plaquette additionnelle (13) sont disposées de sorte que les différentes parts (15a à 15c) de la lumière incidente sur la lentille micro-optique (1A' à 1C') puissent être dirigées vers les différents éléments de détection de lumière (4a à 4e) de l'aménagement de capteurs de lumière (4A à 4C) disposé au moins partiellement au-dessous de cette lentille micro-optique.

6. Composant micro-optoélectronique (100 à 400; 700) pour la photographie de champ de lumière qui présente une pile composée d'une première partie de plaquette (3) et d'une deuxième partie de plaquette (2),
dans lequel la première partie de plaquette (3) présente un matériau semi-conducteur (3a) dans lequel sont formés une pluralité d'aménagements de capteurs de lumière (4A à 4C) et chacun de la pluralité d'aménagements de capteurs de lumière présente une pluralité d'éléments de capteur de lumière (4a à 4e), et
dans lequel la deuxième partie de plaquette (2) présente un matériau optiquement transparent et est structurée de sorte que dans cette dernière soient formées une pluralité de lentilles micro-optiques (1A à 1C, 1A' à 1C'), où chacune de la pluralité de lentilles micro-optiques est, quant à elle, structurée optiquement de sorte que, à partir d'un point (32) d'un objet, les faisceaux de lumière dirigés par une lentille principale (31) sur les lentilles micro-optiques soient dirigés selon différents angles d'incidence (9A à 9C, 10A à 10C; 15a à 15c) vers différents éléments de détection de lumière d'un aménagement de capteurs de lumière (4A à 4C) disposé au moins partiellement au-dessous de ces lentilles micro-optiques,
**caractérisé par le fait que**

le composant micro-optoélectronique (700) présente une fenêtre optiquement transparente (16) dans la première partie de plaquette (3) à travers laquelle de la lumière d'une source de lumière située au-delà d'un côté de la première partie de plaquette (3), opposée à la deuxième plaquette, peut passer à travers la première partie de plaquette.

7. Composant micro-optoélectronique selon la revendication 6, dans lequel la première partie de plaquette (3) est conçue pour un éclairage du côté arrière et la deuxième partie de plaquette (2) est disposée sur un côté arrière (R) de la première partie de plaquette (3).

8. Composant micro-optoélectronique (300; 700) selon l'une des revendications 6 et 7, dans lequel est disposée, entre la première partie de plaquette (3; 3') et la deuxième partie de plaquette (2), une partie de plaquette (13) additionnelle, où la partie de plaquette (13) additionnelle présente des cavités (13A à 13C) qui sont disposées au-dessus des aménagements de capteurs de lumière (4A à 4C) de sorte que la lumière incidente puisse être incidente sur les différents éléments de détection de lumière (4a à 4e).

9. Composant micro-optoélectronique (400; 700) selon l'une des revendications 6 à 8, dans lequel la première partie de plaquette (3') présente des cavités (13A à 13C) qui sont disposées au-dessus des aménagements de capteurs de lumière (4A à 4C) de sorte que la lumière incidente puisse être incidente sur les différents éléments de détection de lumière (4a à 4e).

**FIG 1A**

FIG 1B

FIG 1C

Bereitstellen eines ersten Wafers, der ein Halbleitermaterial aufweist ⟶1110

Bereitstellen eines zweiten Wafers, der ein optisch transparentes Material aufweist ⟶1120

Erzeugen einer Vielzahl von Lichtsensoranordnungen in dem Halbleitermaterial des ersten Wafers für jedes der herzustellenden mikrooptischen Bauelemente ⟶1130

Strukturieren des zweiten Wafers derart, dass darin für jedes der herzustellenden mikrooptoelektronischen Bauelemente eine Vielzahl von mikrooptischen Elementen gebildet ist ⟶1140

Erzeugen eines Waferstapels mittels Waferbonding, der den ersten Wafer und den darüber angeordneten zweiten Wafer aufweist, wobei jedes der mikrooptischen Elemente derart angeordnet und optisch strukturiert ist, dass unterschiedliche Anteile des auf das mikrooptische Element einfallenden Lichts auf unterschiedliche Lichtsensorelemente einer unter diesem mikrooptischen Element zumindest teilweise angeordneten Lichtsensoranordnung gelenkt werden ⟶1150

Vereinzeln des Waferstapels, um die Vielzahl von mikrooptoelektronischen Bauelementen zu erzeugen ⟶1190

# FIG 1D

FIG 1E

EP 2 406 825 B1

# FIG 2A

EP 2 406 825 B1

FIG 3A

300

Bereitstellen eines ersten Wafers, der ein Halbleitermaterial aufweist — 1110

Bereitstellen eines zweiten Wafers, der ein optisch transparentes Material aufweist — 1120

Bereitstellen eines zusätzlichen Wafers — 3110

Erzeugen einer Vielzahl von Kavitäten in dem zusätzlichen Wafer — 3120

Erzeugen einer Vielzahl von Lichtsensoranordnungen in dem Halbleitermaterial des ersten Wafers für jedes der herzustellenden mikrooptischen Bauelemente — 1130

Strukturieren des zweiten Wafers derart, dass darin für jedes der herzustellenden mikrooptoelektronischen Bauelemente eine Vielzahl von mikrooptischen Elementen gebildet ist — 1140

Erzeugen eines Waferstapels mittels Waferbonding, der zwischen dem ersten Wafer und dem zweiten Wafer den zusätzlichen Wafer aufweist, wobei die Kavitäten des zusätzlichen Wafers derart angeordnet sind, dass die unterschiedlichen Anteile des auf das mikrooptische Element einfallenden Lichts auf die unterschiedlichen Lichtsensorelemente der unter diesem mikrooptischen Element zumindest teilweise angeordneten Lichtsensoranordnung gelenkt werden können — 1150'

Vereinzeln des Waferstapels, um die Vielzahl von mikrooptoelektronischen Bauelementen zu erzeugen — 1190

# FIG 3B

FIG 4A

EP 2 406 825 B1

400

Bereitstellen eines ersten Wafers, der ein Halbleitermaterial aufweist —1110

Bereitstellen eines zweiten Wafers, der ein optisch transparentes Material aufweist —1120

Erzeugen einer Vielzahl von Kavitäten in dem ersten Wafer —4110

Erzeugen einer Vielzahl von Lichtsensoranordnungen in dem Halbleitermaterial des ersten Wafers für jedes der herzustellenden mikrooptischen Bauelemente —1130

Strukturieren des zweiten Wafers derart, dass darin für jedes der herzustellenden mikrooptoelektronischen Bauelemente eine Vielzahl von mikrooptischen Elementen gebildet ist —1140

Erzeugen eines Waferstapels mittels Waferbonding, der den ersten Wafer und den darüber angeordneten zweiten Wafer aufweist, wobei jedes der mikrooptischen Elemente derart angeordnet und optisch strukturiert ist, dass unterschiedliche Anteile des auf das mikrooptische Element einfallenden Lichts auf unterschiedliche Lichtsensorelemente einer unter diesem mikrooptischen Element zumindest teilweise angeordneten Lichtsensoranordnung gelenkt werden —1150

Vereinzeln des Waferstapels, um die Vielzahl von mikrooptoelektronischen Bauelementen zu erzeugen —1190

# FIG 4B

FIG 5A

EP 2 406 825 B1

Bereitstellen eines ersten Wafers, der ein Halbleitermaterial aufweist — 1110

Erzeugen einer Vielzahl von Lichtsensoranordnungen in dem Halbleitermaterial des ersten Wafers auf einer ersten Seite desselben für jedes der herzustellenden mikrooptischen Bauelemente — 1520

Strukturieren des Wafers auf einer der ersten Seite des Wafers gegenüberliegenden Seite derart, dass darin für jedes der herzusstellenden mikrooptoelektronischen Bauelemente eine Vielzahl von mikrooptischen Elementen gebildet ist, wobei jedes der mikrooptischen Bauelemente derart angeordnet und optisch strukturiert ist, dass unterschiedliche Anteile des auf das mikrooptische Element einfallenden Lichts auf unterschiedliche Lichtsensorelemente einer unter diesem mikrooptischen Element zumindest teilweise angeordneten Licht-sensoranordnungen gelenkt werden — 1530

Vereinzeln des Waferstapels, um die Vielzahl von mikro-optoelektronischen Bauelementen zu erzeugen — 1190

# FIG 5B

EP 2 406 825 B1

FIG 6A

Bereitstellen eines ersten Wafers, der ein Halbleitermaterial aufweist ⁓1110

Erzeugen einer Vielzahl von Lichtsensoranordnungen in dem Halbleitermaterial des ersten Wafers auf einer ersten Seite desselben für jedes der herzustellenden mikro-optischen Bauelemente ⁓1520

Aufbringen einer Vielzahl von mikrooptischen Elementen auf einer der ersten Seite des Wafers gegenüberliegenden Seite derart, dass für jedes der herzustellenden mikrooptoelektronischen Bauelemente eine Vielzahl von mikro-optischen Elementen gebildet ist, wobei jedes der mikro-optischen Bauelemente derart angeordnet und optisch strukturiert ist, dass unterschiedliche Anteile des auf das mikrooptische Element einfallenden Lichts auf unter-schiedliche Lichtsensorelemente einer unter diesem mikrooptischen Element zumindest teilweise angeordneten Lichtsensoranordnung gelenkt werden ⁓1630

Vereinzeln des Waferstapels, um die Vielzahl von mikro-optoelektronischen Bauelementen zu erzeugen ⁓1190

# FIG 6B

FIG 7A

FIG 8A

| f | BZ | n | R | r | h |
|---|---|---|---|---|---|
| 600 | 4 | 1,47 | 192 | 75 | 15,3 |
| 500 | 4 | 1,47 | 160 | 63 | 12,7 |
| 400 | 4 | 1,47 | 128 | 50 | 10,2 |
| 300 | 4 | 1,47 | 96 | 38 | 7,6 |
| 200 | 4 | 1,47 | 64 | 25 | 5,1 |
| 100 | 4 | 1,47 | 32 | 13 | 2,5 |
| 50 | 4 | 1,47 | 16 | 6 | 1,3 |
| 30 | 4 | 1,47 | 10 | 4 | 0,8 |

| R/f= | r/f= | h/f= |
|---|---|---|
| 32.0% | 12,5% | 2,5% |
| 32.0% | 12,5% | 2,5% |
| 32.0% | 12,5% | 2,5% |
| 32.0% | 12,5% | 2,5% |
| 32.0% | 12,5% | 2,5% |
| 32.0% | 12,5% | 2,5% |
| 32.0% | 12,5% | 2,5% |
| 32.0% | 12,5% | 2,5% |

## FIG 8B

| f | BZ | n | R | r | h |
|---|---|---|---|---|---|
| 600 | 2,8 | 1,47 | 192 | 107 | 32,7 |
| 600 | 4,0 | 1,47 | 192 | 75 | 15,3 |
| 600 | 5,6 | 1,47 | 192 | 54 | 7,6 |
| 600 | 8,0 | 1,47 | 192 | 38 | 3,7 |
| 600 | 11,0 | 1,47 | 192 | 27 | 1,9 |
| 600 | 16,0 | 1,47 | 192 | 19 | 0,9 |
| 600 | 22,0 | 1,47 | 192 | 14 | 0,5 |
| 600 | 32,0 | 1,47 | 192 | 9 | 0,2 |

| R/f= | r/f= | h/f= |
|---|---|---|
| 32.0% | 17,9% | 5,5% |
| 32.0% | 12,5% | 2,5% |
| 32.0% | 8,9% | 1,3% |
| 32.0% | 6,3% | 0,6% |
| 32.0% | 4,5% | 0,3% |
| 32.0% | 3,1% | 0,2% |
| 32.0% | 2,3% | 0,1% |
| 32.0% | 1,6% | 0,0% |

## FIG 8C

| f | BZ | n | R | r | h |
|---|---|---|---|---|---|
| 600 | 4 | 1,45 | 186 | 75 | 15,8 |
| 600 | 4 | 1,50 | 200 | 75 | 14,6 |
| 600 | 4 | 1,55 | 213 | 75 | 13,6 |
| 600 | 4 | 1,60 | 225 | 75 | 12,9 |
| 600 | 4 | 1,65 | 236 | 75 | 12,2 |
| 600 | 4 | 1,70 | 247 | 75 | 11,7 |
| 600 | 4 | 1,75 | 257 | 75 | 11,2 |
| 600 | 4 | 1,80 | 267 | 75 | 10,8 |

| R/f= | r/f= | h/f= |
|---|---|---|
| 31.0% | 12,5% | 2,6% |
| 33.3% | 12,5% | 2,4% |
| 35.5% | 12,5% | 2,3% |
| 37.5% | 12,5% | 2,1% |
| 39.4% | 12,5% | 2,0% |
| 41.2% | 12,5% | 1,9% |
| 42.9% | 12,5% | 1,9% |
| 44.4% | 12,5% | 1,8% |

## FIG 8D

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20080122055 A1
- US 20080290435 A1
- US 20060043262 A1
- US 20070259463 A1
- US 20070052050 A1
- US 5227313 A
- JP 7202149 A
- WO 2008006504 A
- EP 1215729 A
- EP 0840502 A
- JP 2007004471 A

**In der Beschreibung aufgeführte Nicht-Patentliteratur**

- Light Field Photography with a Hand-held Plenoptic Camera. Ren Ng et Al. Stanford Tech Report. CTSR, 2005, vol. 02, 1-11